# EUROPEAN PATENT APPLICATION

(11) **EP 4 672 073 A1**
(43) Date of publication of application: **31.12.2025**
(21) Application number: 25178050.8
(22) Date of filing: 21.05.2025
(51) Int. Cl.: G06F 30/12, G06F 30/27, G06N 3/0475

(54) **PROFILE-BASED PROMPT ENGINEERING FOR USER-SPECIFIC INDUSTRIAL AUTOMATION PROJECT CUSTOMIZATION**

(30) Priority: 26.06.2024 US 202418754601
(71) Applicant: Rockwell Automation Technologies, Inc., Mayfield Heights, OH 44124 (US)
(72) Inventor: Frank, Brian C., Mayfield Heights, OH, 44124 (US); Renderman, Gerald W., Mayfield Heights, OH, 44124 (US); Mason, John P., Mayfield Heights, OH, 44124 (US); Hill, Matthew S., Mayfield Heights, OH, 44124 (US); Moua, Chao G., Mayfield Heights, OH, 44124 (US)
(74) Representative: Grünecker Patent- und Rechtsanwälte PartG mbB

(57) **Abstract**

The disclosure relates to an industrial design application that provides a customized user experience. In response to a user request for a design of an industrial system, the industrial design application selects generic base designs from a base design repository. Embodiments include a Generative Artificial Intelligence (GAI) model trained to generate user-customizations of the generic base designs. Once a user receives a customized base design, the user may make modifications to the customized base designs. Finalized designs may be provided to the GAI model for training on common selections made by users of the industrial design application.

## Description

### RELATED APPLICATIONS

This U.S. Patent Application is related to co-pending U.S. Patent Application titled "COMMON CONFIGURATION VALIDATION IN INDUSTRIAL DESIGN APPLICATIONS USING GENERATIVE ARTIFICIAL INTELLIGENCE," Attorney Docket Number 2024P-026-US, filed concurrently, the contents of which are incorporated herein in their entirety for all purposes.

This U.S. Patent Application is related to co-pending U.S. Patent Application titled "INDUSTRIAL BASE DESIGN GENERATION USING GENERATIVE ARTIFICIAL INTELLIGENCE," Attorney Docket Number 2024P-028-US, filed concurrently, the contents of which are incorporated herein in their entirety for all purposes.

This U.S. Patent Application is related to co-pending U.S. Patent Application titled "UPDATING BASE DESIGNS IN INDUSTRIAL DESIGN APPLICATIONS USING GENERATIVE ARTIFICIAL INTELLIGENCE," Attorney Docket Number 2024P-029-US, filed concurrently, the contents of which are incorporated herein in their entirety for all purposes.

### TECHNICAL FIELD

The disclosure generally relates to utilizing Generative Artificial Intelligence (GAI) models, such as Large Language Models (LLMs) or Multi-Modal Models (MMMs), to provide user-specific customizations of industrial designs, and more specifically to user-specific customization base designs for use in industrial design applications.

### BACKGROUND

In preparation for building, updating, or modifying industrial systems in a factory, an engineer may use an industrial design application to plan details, including selecting components (e.g., machines, controllers, cabinets, and the like), selecting configuration settings of the components, and designing layouts of the system. Once configured, the engineer can submit the design for quoting using the industrial design application. There are many configuration options for users to select in designing any portion of an industrial system. Such options may include, for example, the types and models of components, unit configuration selections, levels of safety, mounting arrangements, and the like. Since the industrial design application may be used by many users, there are challenges in maintaining customized selection information based on past usage. As such, when a user of the application begins a new project, the user may need to input the same configuration selections that have already been selected several times for previous projects. Furthermore, novice users of the industrial design application may not be experienced with the multitude of industrial parameters that are presented to them.

Existing systems typically offer base designs that are generalized for a given industry type and location (e.g., beverage factory in Mexico, oil and gas in New Zealand, etc.). These base designs may be customized by each user during the pre-sale phase in an industrial design application. However, each customized design is not typically stored into a centralized repository due to cost and storage constraints. Accordingly, improvements are needed to allow users to leverage prior customizations in industrial design applications.

### SUMMARY

This disclosure describes an industrial design application that assists users during the design of an industrial automation project. The industrial automation project may include a design of one or more industrial automation devices. The industrial design application may be utilized in the pre-sale phase of the industrial automation project, in which customers design the industrial automation project and submit requests for quotes for the designs. The industrial design application provides users with designs of industrial automation devices, systems, or units such as Motor Control Centers (MCC), power distribution systems, manufacturing lines, and other industrial components, and the design may include as few as one industrial automation device or as many as are needed to operate an entire factory. The industrial design application quickly provides users with unique designs for simple or complex industrial automation projects and provides users with the ability to easily customize the designs. A Generative Artificial Intelligence (GAI) model, such as a Large Language Model (LLM) or Multi-Modal Model (MMM), is used to generate customized designs for the user of the application based on learned preferences of the user. The use of the GAI model increases ease of use of the application, as it provides customized designs that align with user preferences and industry standards, while reducing the number of selections a user needs to make when designing an industrial system.

One example of a computer implemented method performed according to some embodiments includes receiving, via a user interface of an industrial design application, a request from a user for a design of an industrial automation project. The request includes one or more system parameters. The method further includes selecting, based on the one or more system parameters, a first generic base design from a base design repository. The first generic base design is one of a plurality of generic base designs stored in the base design repository. Each of the generic base designs includes metadata defining an industrial unit. The metadata of the first generic base design includes a first selection of a configurable attribute. The method further includes generating a prompt to elicit a response from a generative artificial intelligence (GAI) model trained on data including prior designs associated with the user. The prompt includes the metadata of the first generic base design, a user identification associated with the user, and a request for a customization of the first generic base design for the user. The method further includes submitting the prompt to the GAI model. The method further includes receiving, from the GAI model in response to the prompt, a first customized base design. The first customized base design includes one or more configurable attributes that differ from corresponding configurable attributes in the first generic base design and are representative of selections in the prior designs associated with the user.

In some embodiments, the method further includes providing the first customized base design to the user via the user interface. The method may further include receiving a finalized unit design from the user via the user interface, where the finalized unit design comprises one or more modifications to the first customized base design. The modifications are made by the user in the user interface of the industrial design application.

In some embodiments, the method further includes submitting the finalized unit design to the GAI model as feedback to train the GAI model on selections of configurable attributes associated with the user.

In some embodiments, the method further includes providing the GAI model with static data during initial training. The static data includes one or more of: industrial product literature, industry standard data, existing base designs, and safety requirements data.

In some embodiments, the user is one of a plurality of users of the industrial design application. In some embodiments, the method may further include providing the GAI model with historical user data during user-specific training. The historical user data includes past industrial configuration submissions, each past industrial configuration submission being associated with one of the plurality of users.

Some embodiments of the method further include selecting, based on the one or more system parameters, a set of generic base designs from the plurality of generic base designs in the base design repository. The set of generic base designs includes the first generic base design. The method further includes generating a respective prompt for each generic base design in the set of generic base designs. Each respective prompt includes the metadata of the respective generic base design, the user identification, and a request for customization of the respective generic base design for the user; receiving, from the GAI model in response to the plurality of prompts, a set of customized base designs corresponding to the set of generic base designs, wherein the set of customized base designs includes the first customized base design; and generating a design layout comprising an arrangement of the set of customized base designs, wherein each customized base design in the set of customized base designs corresponds to an industrial unit in the industrial automation project.

In some embodiments, the system parameters of the request may include an industry, an installation location, a load list, a company name, a job function, a language preference, or any combination for the industrial automation project.

In some embodiments, the request for the design for the industrial automation project includes a request for a design of a Motor Control Center. The first customized base design includes a customized configuration for a motor controller in the Motor Control Center.

These and other features and aspects of various examples may be understood in view of the following detailed discussion and accompanying drawings.

### BRIEF DESCRIPTION OF THE DRAWINGS

Fig. 1 illustrates an industrial automation project design customization system, according to some embodiments.
Fig. 2 illustrates a logical view of exemplary base design elements, according to some embodiments.
Fig. 3 illustrates a view of the cloud service of Fig. 1, according to some embodiments.
Figs. 4A and 4B illustrate a method for industrial automation project design customization, according to some embodiments.
Fig. 5 illustrates an operational scenario for the industrial automation project design customization system of Fig. 1, according to some embodiments.
Figs. 6A - 6D illustrate example user interfaces of an industrial design application, according to some embodiments.
Fig. 7 illustrates prompt templates, according to some embodiments.
Fig. 8 illustrates an exemplary computing system, according to some embodiments.

### DETAILED DESCRIPTION

This disclosure relates to the use of a Generative Artificial Intelligence (GAI) model, (e.g., a Large Language Model (LLM) or Multi-Modal Model (MMM)), to provide user-specific customization in an industrial design application. The industrial design application assists users in the design and procurement of industrial automation projects. Industrial automation projects may include one or more industrial automation devices. Individual industrial automation devices may include, for example, drives, controllers, conveyors, and the like. An industrial automation project may include a design, for example, for Motor Control Centers (MCCs), power distribution systems, and factory lines. These projects may include a combination of industrial automation devices including industrial automation drives, industrial automation controllers, a cabinet for the industrial automation devices, and the like. An industrial design project for an entire factory may include all industrial automation devices needed to operate a factory. The industrial design application quickly provides users with unique designs for industrial automation projects and provides the users with the ability to easily customize the designs. The industrial design application may be utilized in the pre-sale phase of industrial automation projects. In the pre-sale phase, the user accesses the industrial design application to design the industrial automation project and request a quote.

There may be many relevant parameters involved in the design of an industrial automation project. For example, in the case of an MCC, relevant parameters may include the voltage and frequency of power provided to the MCC, the load utilization, the specific models of motor controllers desired, the type of operating stations for different types of motor controllers, and safety standards such as arc fault certification requirements, among many other parameters. All these options could be presented to a user before generating the layout of the industrial automation project. However, the large number of options may make it difficult for users to make optimal selections, and novice users may be at a particular disadvantage.

Additionally, users may be forced to repeatedly select the same configuration options each time the user creates a new industrial automation project. It is difficult to maintain and apply a database of user-specific preferences for endless users and countless configurable parameters in the industrial design application, especially since user preferences and company-specific preferences tend to change over time.

To address the above-described issues, an improved industrial design application is disclosed that leverages a GAI model to provide a user-customized experience for each user of the industrial design application. In response to a user request for a design of an industrial automation project (i.e., one or more industrial automation devices), at least one base design is selected to meet the initial request. Additionally, a prompt is generated requesting the GAI model customize the base design for the specific user. The customized base design is received from the GAI model, where the customized base design has configuration selections aligning with previous design selections specific to the user making the request. The model-generated design (i.e., the customized base design) may also be configured to comply with learned industry standards, including common configurations and safety standards.

These features increase ease of use for users of the industrial design application. Experienced users may receive customized designs without having to make the same selections repeatedly. Inexperienced users may receive designs that comply with industry standards without being presented with a multitude of parameters they may not be experienced with. As disclosed, leveraging a GAI model to customize a user experience is faster, more efficient, and more accurate than other methods of determining and maintaining user preferences. For example, selections and customizations can be applied to base designs without specific prior access by a given user. The system may improve efficiency because individual preferences for all possible configuration options do not need to be stored, and specific base designs customized for each user do not need to be pre-generated and stored. Rather, the system can generate customizations on-the-fly, using limited prior information for any given user.

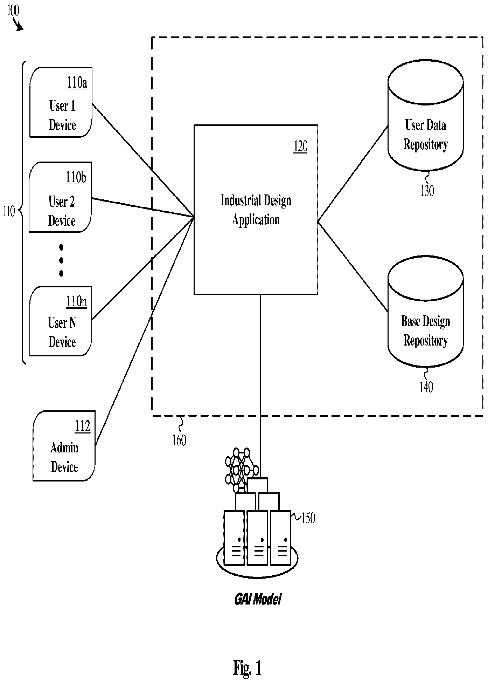

**Fig. 1** illustrates system 100 according to some embodiments. System 100 includes user devices 110, admin device 112, cloud platform 160, and GAI model 150. While specific elements of system 100 are shown for ease of description, system 100 may include more or fewer of each described component as well as other components not described for simplicity.

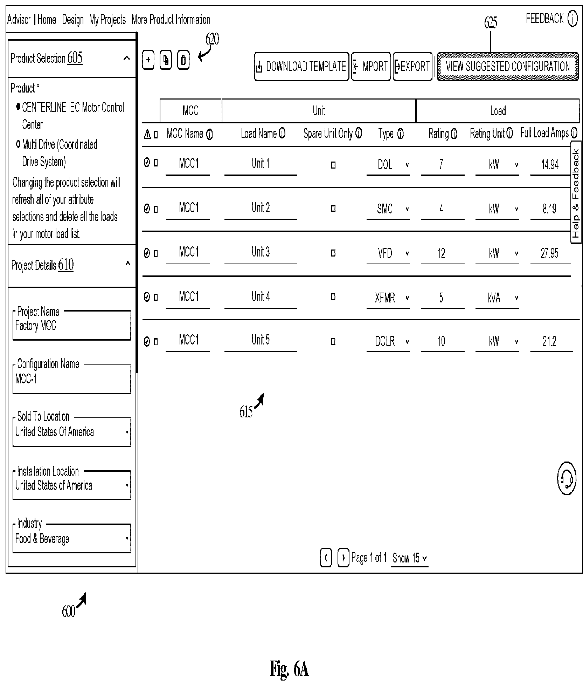

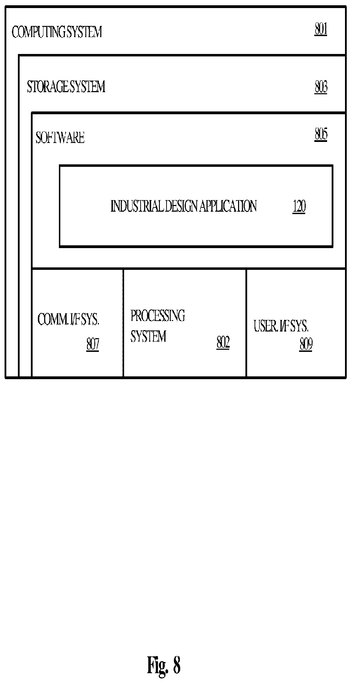

User devices 110 include user 1 device 110a, user 2 device 110b, and user N device 110n. While three user devices are shown in Fig. 1 for simplicity, system 100 may include any number N of user devices 110. User devices 110 may include computers, laptops, mobile devices such as smartphones or tablets, or any other similar device capable of interfacing with industrial design application 120. Users may access industrial design application 120 on user devices 110. Specifically, users may log in to a user account on a web browser on the user device to access industrial design application 120. In some embodiments, the users may open an application program on user device 110 to access industrial design application 120. In either case, industrial design application 120 provides a user interface to display to the user on user device 110. Exemplary user interfaces 600 are shown in Figs. 6A - 6D. User devices 110 may be computing system 801 described with respect to FIG. 8.

A user may interact with the user interface on user device 110 to make a request for a design of an industrial automation project. Such a request may be made in the pre-sale phase of the industrial automation project. The industrial automation project may include one or more industrial automation devices, including a layout of physical components for installation, for example, on a factory floor. In the pre-sale phase, the user may design and configure the industrial automation project using the user interface on user device 110. Once the user is satisfied with the industrial automation project design, the user may request a quote for the designed industrial automation project (i.e., each of the configured industrial automation devices in the industrial automation project).

To make the request for the design, the user may input parameters of the industrial automation project in the user interface of user device 110. In some embodiments, the parameters include the relevant industry (e.g., "Automotive" or "Food/Beverage") and the installation location (e.g., country, city, region, or the like) in which the industrial automation project is to be implemented. Parameters may also include a load list, setting forth the required functionality of the industrial automation project. When the industrial automation project is an MCC, the load list may be a motor-load list, in which the user inputs the types of motor controllers (e.g., Direct Online Starter (DOL), Variable Frequency Drive (VFD), etc.) required in the MCC, as well as other relevant parameters such as the required power rating for each motor controller. Once the user has input the parameters, the user may submit the request for the design of the industrial automation project via the user interface of user device 110.

In some embodiments, to make the request for the design, the user may upload a file (e.g., the process layout file or schematic file) as a parameter or even as the only parameter. The system may extract relevant data from the file including, for example, installation location, relevant industry, load list, and the like. The system may use artificial intelligence models, including GAI models, to extract the relevant data and otherwise interpret the file. In some embodiments, for example, the system may interpret the file by generating a prompt asking the GAI model to analyze the file and provide a summary of details including a bill of materials based on the user and the file. In some embodiments, the system may extract relevant data from the file using an AI model that is trained to extract particular data from the particular type of file, for example. The extracted data may be used as context for interpreting the file using an AI model trained to analyze the particular type of file (e.g., schematic file, process layout file, or the like) and generate a bill of materials based on the file. Based on the bill of materials, the user information, and any other parameters extracted or provided by the user, the system may select the relevant generic base designs. The selected generic base designs may then be customized for the specific user using the process described in method 400 below (e.g., including generating a prompt including the generic base designs, information about the user, and so forth). Further, in such embodiments, the system may include the file as contextual information included in the prompt.

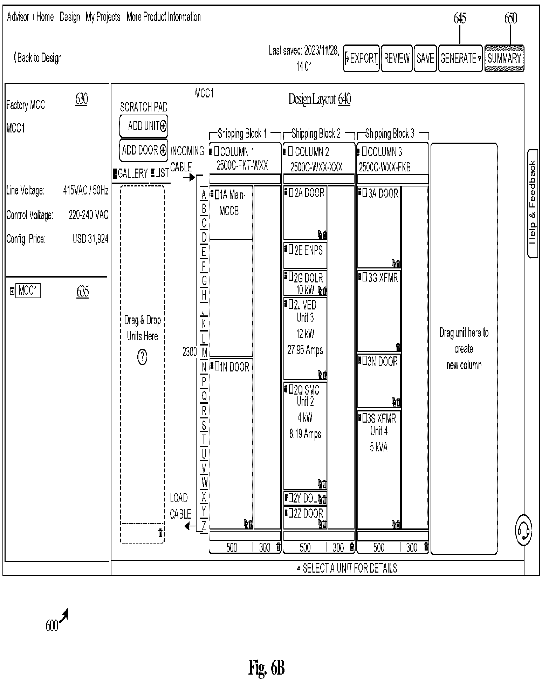

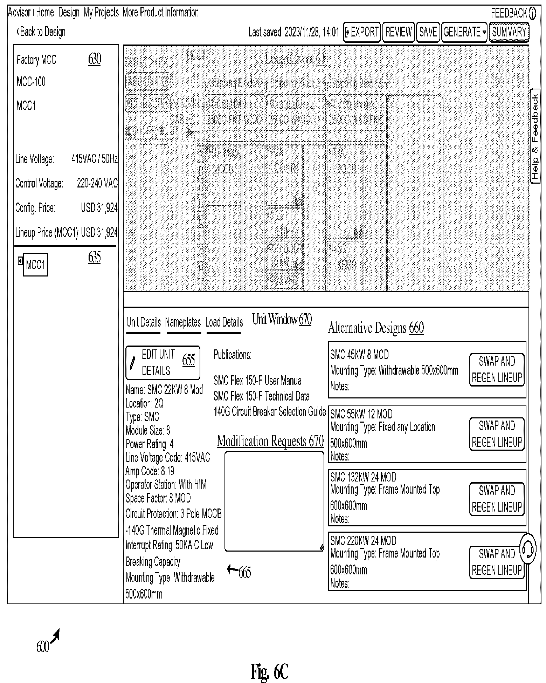

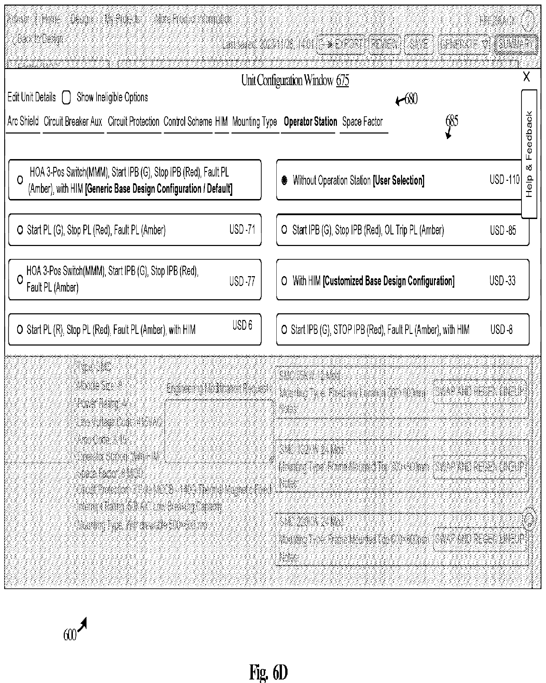

Generated designs for the industrial automation project are provided to users via the user interfaces of user devices 110, in response to design requests. The generated design includes one or more customized base designs and an arrangement of the customized base designs including physical placement, connections, and the like when appropriate. The customization of base designs is discussed in further detail below. Each customized base design is a design for a fully functional industrial unit, customized by GAI model 150 based on learned user preferences. A fully functional industrial unit may be a single industrial automation device (e.g., a programmable logic controller, a drive, or the like) or it may be a combination of industrial automation devices arranged into a common configuration (e.g., a motor control center (MCC)). The generated design may include a complete layout for a set of customized base designs. A generated design for an MCC is shown, for example, in Fig. 6B, which includes an arrangement of motor controllers in a series of columns. Once the user receives the design, the user may make modifications to the generated design, as discussed in detail in Fig. 6C and 6D below. For example, the user may modify configuration options, remove, or add base designs for one or more industrial units, or the like. Once the user is satisfied with the design of the industrial automation project, the user may submit the finalized project. The submission of the finalized project may include, for example, a request for a quote. Users may also interact with the user interfaces of user devices 110 to perform other tasks such as submitting feedback, viewing help topics, reporting bugs, requesting live customer assistance, and viewing product catalogues, for example.

Admin device 112 is used by administrators to perform administrative tasks in industrial design application 120. While one admin device 112 is shown in Fig. 1 for simplicity, system 100 may include multiple admin devices 112 utilized by multiple administrators of industrial design application 120. Admin devices 112 may include computers, laptops, mobile devices such as smartphones or tablets, or any other similar device. Administrators may access industrial design application 120 via user interfaces on admin devices 112. The user interfaces may be viewed, for example, in web browsers accessing industrial design application 120 remotely, in specialized locally installed applications that access industrial design application 120 remotely, or directly in a locally installed implementation of industrial design application 120. Functions performed by administrators may include updating software of industrial design application 120, maintaining generic base designs in base design repository 140, and the like. Admin devices 112 may be computing system 801 described with respect to Fig. 8.

Cloud platform 160 includes industrial design application 120, user data repository 130, and base design repository 140. Cloud platform 160 may optionally include Generative Artificial Intelligence (GAI) model 150 in some embodiments. Cloud platform 160 operates from servers which may be located in data centers, distributed in various geographic locations, and the like. Various software components of cloud platform 160 may have multiple instances in different geographic locations for redundancy and speed.

Industrial design application 120 includes software operating from servers in cloud platform 160. Industrial design application 120 may be a web-based application that assists users in the design of industrial automation projects. Industrial design application 120 may be utilized in the pre-sale phase of industrial automation projects. In the pre-sale phase, industrial design application 120 is used to assist users in designing and configuring the industrial automation projects, and to provide quotes to the users for the industrial automation projects. Industrial design application 120 generates a design of industrial units (e.g., one or more industrial automation devices) based on parameters defined by the user. For example, in the process of assisting in the design of an MCC, industrial design application 120 may generate a layout of motor controllers and other components (e.g., circuit breakers and power buses) to meet the requirements of a user's design request.

Industrial design application 120 interacts with user devices 110, admin devices 112, user data repository 130, base design repository 140, and GAI model 150 to perform various functions as discussed below. Industrial design application 120 may be computer software implemented on one or more servers and/or in a cloud-based environment. Industrial design application 120 may be implemented in memory on a server such as, for example, computing system 801 as described with respect to Fig. 8.

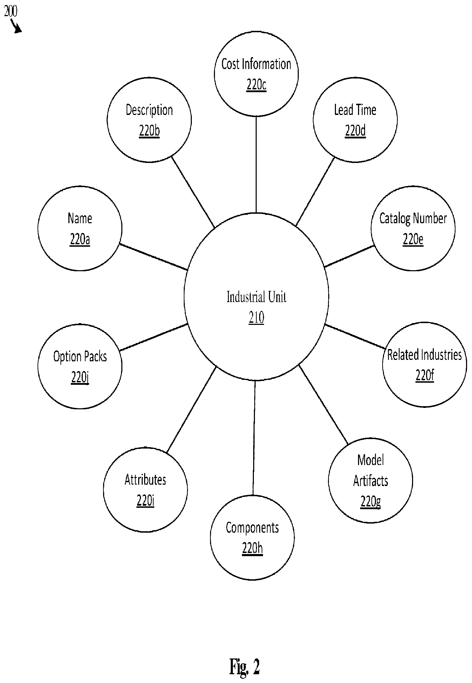

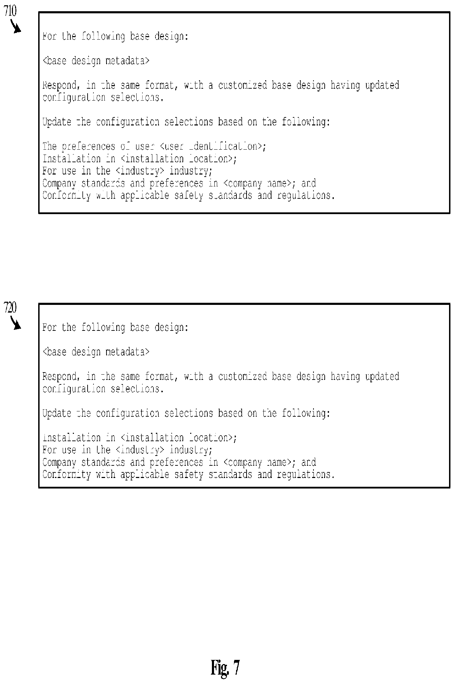

Industrial design application 120 receives requests from users for designs of industrial automation projects. Such requests may include parameters defined by users, as discussed above. Based on the parameters in the user request, industrial design application 120 selects generic base designs for customization. For example, in the case in which the request is for the design of an MCC, industrial design application 120 may select a generic base design from base design repository 140 for a motor controller for each load included in the motor-load list of the request. The selection of a generic base design may be based on the type of motor controller requested (e.g., VFD) as well as other stated requirements (e.g., power ratings) in the parameters. Once the generic base designs are selected, industrial design application 120 may retrieve metadata for each of the identified generic base designs from the base design repository 140. The metadata is discussed in further detail in Fig. 2 below. Once the metadata is retrieved, industrial design application 120 may generate one or more prompts for GAI model 150. The prompts may include the metadata for the selected generic base designs, and a request to respond with a customized base design aligning with learned user preferences for the specified user that requested the design. In some embodiments, a separate prompt may be generated for each generic base design selected. In other embodiments, one prompt may be generated that includes metadata (for example, some or all metadata 220 of Fig. 2) for all of the selected generic base designs. The prompt may be generated using a prompt template, for example, prompt template 710 of Fig. 7. In cases in which the user is a first-time user, prompt template 720 of Fig. 7 may be used, as discussed in further detail below. Once the prompt has been generated, industrial design application 120 submits the prompt to GAI model 150.

In response to submitting the prompts, industrial design application 120 receives customized base designs from GAI model 150. Upon receiving the customized base designs, industrial design application 120 may generate a layout for the industrial automation project when needed, where the layout includes an arrangement of the customized base designs, to generate a complete industrial automation project design. Industrial design application 120 provides the complete industrial automation project design to users via user interfaces on user devices 110. An exemplary design is shown in the user interface in Fig. 6B. As noted above, users may make modifications to the layout. The user may make any desired changes and submit the finalized industrial automation project. Industrial design application 120 may provide the user with a quote for purchase of the industrial automation project as designed. In some embodiments, industrial design application 120 may connect the user with a sales representative. Industrial design application 120 may provide the finalized industrial automation project to GAI model 150 as feedback for updating learned user preferences in GAI model 150 as discussed further in method 400 below.

User data repository 130 is a database storing information about each user of industrial design application 120. In some embodiments, user data repository 130 may include basic information about each user such as login information, contact information, and the user's organization or company. User data repository 130 may also include historical user data including previous industrial automation project design configurations submitted by the user, and previous industrial automation projects purchased by the user. This historical user data may be provided to GAI model 150 for user-specific training, as discussed in further detail in method 400 below. The user data in user data repository 130 may be stored in memory of a server or other data storage device of cloud platform 160.

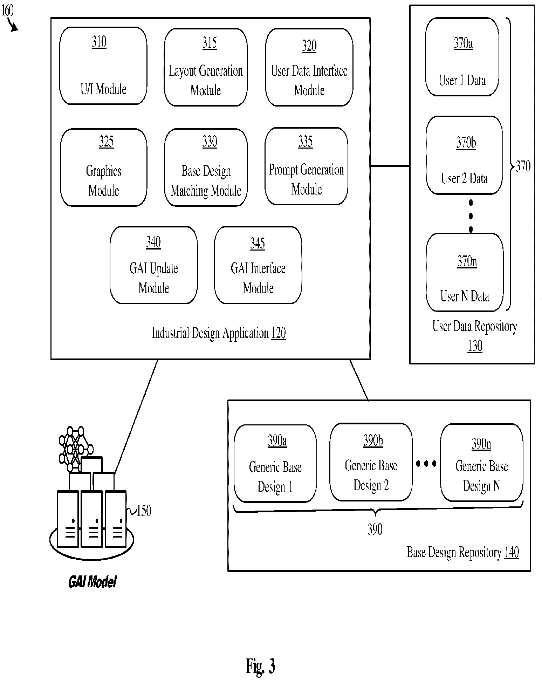

Base design repository 140 is a database that may contain generic base designs of industrial units. Industrial units include one or more industrial automation devices and are described in more detail with respect to Fig. 2. Each generic base design (generic base designs 390 described with respect to Fig. 3) in base design repository 140 includes a generic design configuration for a fully functional industrial unit. Generic base designs are described in more detail with respect to base design 200 of Fig. 2. Metadata for each generic base design, for example metadata 220 of Fig. 2, is stored in base design repository 140. The metadata includes detailed information defining a fully functional industrial unit, as discussed further in Fig. 2 below. The metadata may include option packs for the industrial units. Option packs include various options for configurable aspects of the industrial unit. For example, a base design for a VFD could include an "Operator Station" option pack. A user may thus choose between different types of operator stations, such as an operator station having a Human Interface Module (HIM) or an operator station having a combination of a HIM and indicator lights. Each option pack may include a default selection. GAI model 150 may customize base designs by altering selections within option packs, as discussed in further detail below, based on prompts designed and submitted by industrial design application 120. As noted above, the metadata of the generic base designs are used by industrial design application 120 for generating the prompts for GAI model 150 requesting user-specific customization. The generic base designs in base design repository 140 may be stored in memory of a server or other data storage device of cloud platform 160.

GAI model 150 is a generative artificial intelligence model trained to perform industrial design tasks. GAI model 150 may include a system of transformer-based neural networks with a vast number of parameters (e.g., weights and balances). The parameters may be adjusted during training for learning information, including industrial data and user specific preferences. Training GAI model 150 is discussed in further detail in method 400 below. GAI model 150 may be a large language model (LLM) trained on a vast amount of textual data. An LLM is capable of processing textual inputs to generate textual outputs. In some embodiments, GAI model 150 is a Multi-Modal Model (MMM). An MMM may be trained on a vast amount of various types of data, including, for example, textual data, video, audio, images, 3-D renderings, CAD files, and other various forms of media. An MMM may be capable of processing inputs and generating outputs in each of these formats. GAI model 150 may be implemented on a computing system (e.g., computing system 801 of Fig. 8), typically in a cloud-based environment due to the processing and memory resources needed to support GAI model 150. However, on-premises implementations are within the scope of this disclosure. Further, GAI model 150 is depicted outside of cloud platform 160. However, in some embodiments, GAI model 150 may be hosted within cloud platform 160, for example, as an enterprise-specific instance.

As discussed above, GAI model 150 receives prompts from industrial design application 120. The prompts may include the metadata of one or more base designs and a request to respond with a customized base design for a specific user. In some embodiments, the prompt also includes a user identification associated with the requesting user. The prompt may also, in some embodiments, include an industry and an installation location for the industrial automation project. GAI model 150 utilizes all the information in the prompt as contextual information to generate base designs customized specifically for the requesting user. Specifically, GAI model 150 may have learned preferences of a specific user during the training and feedback processes discussed in further detail below. GAI model 150 may have learned, for example, that a certain user usually selects thermal circuit breakers for Direct On Line (DOL) motor controllers. Thus, when a prompt is provided to GAI model 150 to customize a generic base design for a DOL motor controller that has a magnetic circuit breaker as a default, the customized base design for the DOL motor controller generated by GAI model 150 may include a thermal circuit breaker instead of the default option. In some cases, GAI model 150 may not have learned user preferences for certain options or certain users. In such cases, GAI model 150 may provide customized base designs that align with the industry and installation locations provided in the prompt or maintain the default selections for some options in the generic base design.

GAI models (also known as foundation models) are models trained to generate new data based on a training dataset. GAI models as used herein include large-scale generative artificial intelligence (AI) models trained on massive quantities of diverse, unlabeled data. The GAI models learn using self-supervised, semi-supervised, or unsupervised techniques. GAI models perform many downstream tasks based on capturing general knowledge, semantic representations, and patterns and regularities in the training data. In some embodiments, such as embodiments included herein, a GAI model may be fine-tuned for specific downstream tasks. GAI models include BERT (Bidirectional Encoder Representations from Transformers) and ResNet (Residual Neural Network). GAI models may be based on any relevant architecture, including, for example, generative adversarial networks (GANs), variational auto-encoders (VAEs), and transformer models, including multimodal transformer models. Depending on the type of input accepted and output provided, GAI models may be multimodal or unimodal.

Multimodal models are a class of GAI model that accepts multimodal data including text, image, video, and audio data. Multimodal models may leverage techniques like attention mechanisms and shared encoders to fuse information from different modalities and create joint representations. Learning joint representations across different modalities enables multimodal models to generate multimodal outputs that are coherent, diverse, expressive, and contextually rich. For example, multimodal models can generate a caption or textual description of a given image by extracting visual features using an image encoder, then feeding the visual features to a language decoder to generate a descriptive caption. Similarly, multimodal models can generate an image based on a text description (or, in some scenarios, a spoken description transcribed by a speech-to-text engine). Multimodal models work in a similar fashion with video-generating a text description of the video or generating video based on a text description.

Multimodal models include visual-language foundation models, such as CLIP (Contrastive Language-Image Pre-training), ALIGN (A Large-scale ImaGe and Noisy-text embedding), and ViLBERT (Visual-and-Language BERT), for computer vision tasks. Examples of visual multimodal or foundation models include DALL-E, DALL-E 2, Flamingo, Florence, and NOOR. Types of multimodal models may be broadly classified as or include cross-modal models, multimodal fusion models, and audio-visual models, depending on the particular characteristics or usage of the model.

Large language models (LLMs) are a type of GAI model that process and generate natural language text. These models are trained on massive amounts of textual data. LLMs learn to generate relevant responses given a prompt or input text. The responses are coherent and contextually relevant to the given prompt. LLMs understand and generate sophisticated language based on their training. LLMs capture intricate patterns, semantics, and contextual dependencies in textual data. In some cases, LLMs may be used in multimodel models. For example, the LLM intelligence is used to combine images and audio input with textual input to generate multimodal output. Types of LLMs include language generation models, language understanding models, and transformer models.

Transformer models, including transformer-type foundation models and transformer-type LLMs, are a class of deep learning models used in natural language processing (NLP). Transformer models are based on a neural network architecture which uses self-attention mechanisms to process input data and capture contextual relationships between words in a sentence or text passage. Transformer models weigh the importance of different words in a sequence, allowing them to capture long-range dependencies and relationships between words. GPT (Generative Pre-trained Transformer) models, BERT (Bidirectional Encoder Representations from Transformer) models, ERNIE (Enhanced Representation through kNowledge IntEgration) models, T5 (Text-to-Text Transfer Transformer), and XLNet models are types of transformer models which have been pretrained on large amounts of text data using a self-supervised learning technique called masked language modeling. For example, large language models, such as ChatGPT and its brethren, have been pretrained on an immense amount of data across virtually every domain of the arts and sciences. This pretraining allows the models to learn a rich representation of language that can be fine-tuned for specific NLP tasks, such as text generation, language translation, or sentiment analysis. Moreover, these models have demonstrated emergent capabilities in generating responses that are creative, openended, and unpredictable.

In practice, a user desiring to design an industrial automation project may log in to a user account via an internet browser on user device 110. The user may create a request for a design of an industrial automation project (e.g., an MCC) via a user interface of industrial design application 120 (for example, user display 600 in Fig. 6A). When creating a request for an MCC, the user may create a list of motor controllers (a motor-load list) to be included in the MCC. Each motor controller may correspond to an industrial component that will be a load for the given motor controller. For example, the industrial components may include a pump or a conveyor that the user wishes to drive from the MCC.

In addition to the motor-load list, the user's request may include other parameters for the industrial automation project. For example, in some embodiments, the user is provided with only two initial prompts: "industry" in which the user selects the relevant industry for the MCC from a drop-down list, and "installation location" which indicates which country, city or region in which the MCC will be installed. Other embodiments may include requests for additional background information, such as "Project Name," "Configuration Name," and "Sold to Location." It is noted that the background prompts may be administrative information that may not affect the design of the industrial automation project.

Accordingly, in some embodiments, the design for the industrial automation project (e.g., an MCC) may be generated based only on the submitted parameters (e.g., the motor-load list) and two additional user inputs (industry and installation location). Although there may be many other configurable parameters in an industrial automation project, industrial design application 120 can generate an initial design of the industrial automation project with limited information. In the example of an MCC, industrial design application 120 may generate a design for an MCC based on the motor-load list, the install location, and the industry. Instead of providing the user with a multitude of selectable parameters at the start of the process, industrial design application 120 utilizes GAI model 150 to make appropriate configuration selections. As discussed in greater detail below, industrial information and user history are used to train GAI model 150 to provide relevant results in response to a prompt. The limited initial required information increases ease of use for novice users who may not be experienced with all the parameters of an industrial automation project. It also increases ease of use for experienced users, who can start a new industrial automation project without repeatedly making the same selections to adjust default configurations.

When industrial design application 120 receives the user's request (e.g., including the motor-load list, the industry, and the installation location) for, in this example, an MCC, industrial design application 120 selects generic base designs from base design repository 140 to respond to the initial request. For example, a generic base design is selected from base design repository 140 for each motor controller included in the motor-load list of the request. A generic base design is a default configuration for an industrial unit (i.e., one or more industrial automation devices). In the case of an MCC, a generic base design may include a default configuration for one industrial automation device, such as a generic base design and default configuration for a motor controller such as a VFD. In some embodiments, the generic base design may be for a more complex industrial unit, such as an entire MCC including a default configuration and arrangement for multiple motor controllers and other industrial automation devices needed to operate the MCC.

Once industrial design application 120 receives the generic base designs from base design repository 140, industrial design application 120 generates one or more prompts for GAI model 150. In some embodiments, a prompt includes the metadata of all the generic base designs received from base design repository 140. In other embodiments, metadata associated with each generic base design selected may be provided to GAI model 150 in a separate prompt for separate customization of each generic base design. The prompt may also include a user identification associated with the user to indicate to GAI model 150 which user-specific preferences should be utilized to generate a customized base design. The prompt may also include the industry and the installation location, such that GAI model 150 may provide customizations in accordance with applicable industry safety standards, laws, and regulations, as requested by the prompt. The prompt may further include the company of the user (which may be retrieved from user data repository 130) such that the GAI model 150 may provide customizations in accordance with the company standards and preferences of the user's company. To generate a prompt, industrial design application 120 may fill in placeholders in a prompt template (e.g., prompt templates 710, 720 of Fig. 7) with the relevant information.

Once the prompt is generated, industrial design application 120 provides the prompt to GAI model 150. In response to the prompt, GAI model 150 generates a customized base design for each generic base design in the prompt. The customized base design is a modified version of the generic base design. The modifications to the generic base design are made by GAI model 150 based on learned user preferences. For example, a generic base design for a Variable Frequency Drive (VFD) may include a removable mounting arrangement. When a particular user is designing an industrial automation project, the user may typically modify the VFD to have a fixed mounting (e.g., for cost-saving purposes). In a user-specific training process, GAI model 150 may have learned that the user generally modifies VFDs to include a fixed mounting. In such a case, the customized base design generated by GAI model 150 may include a VFD with a fixed mounting rather than a default removable mounting.

When an industrial design application has many users, it is impractical to determine and apply detailed preferences for each individual user using traditional processing methods, especially as preferences may change over time. There may be extensive historical user data associated with each user including industrial automation projects submitted in the past. The use of GAI model 150 improves the process of maintaining user preferences. GAI model 150 may be trained on historical user data to determine user-specific preferences of each user. In some embodiments, GAI model 150 may be trained to give greater weight to more recent selections by users. Accordingly, leveraging GAI model 150 allows industrial design application 120 to provide customized designs to users that are adapted to a user's changing preferences.

After industrial design application 120 receives the customized base designs from GAI model 150, industrial design application 120 may generate a layout for a combination of customized base designs, which creates a complete industrial automation project design to respond to the user's request. In the example in which the industrial automation project is an MCC, industrial design application 120 generates a layout of motor controllers and other industrial automation devices (e.g., circuit breakers and power buses). The generated layout may include, for example, the location of each component in one or more cabinets.

Once the layout is generated, the designed industrial automation project is displayed to the user via user device 110a. The user may view a graphical representation of the industrial automation project including the customized base designs. The user may need to further modify one or more of the customized base designs (see, for example, Figs. 6C and 6D). Once the user has completed all needed modifications, the user may submit the finalized industrial automation project of the MCC for a quote.

Upon receiving the submission, industrial design application 120 may generate and supply a quote to the user. Industrial design application 120 may perform other functions, including, for example, connecting the user with a live agent, such as a sales representative. Industrial design application 120 may also generate a feedback input for GAI model 150, where the feedback input includes the user's finalized design of the industrial automation project. GAI model 150 may use the feedback input to update learned user preferences associated with the user.

**Fig. 2** illustrates a schematic view of base design 200 according to some embodiments. Base design 200 contains detailed design data about a specific industrial unit 210. Base design 200 of Fig. 2 may be representative of the generic base designs stored in base design repository 140 of Fig. 1. Base design 200 may also be representative of the customized base designs provided to users, as described herein. Base design 200 includes industrial unit 210 and metadata 220. Metadata 220 includes name 220a, description 220b, cost information 220c, lead time 220d, catalog number 220e, related industries 220f, model artifacts 220g, components information 220h, attributes 220i, and option packs 220j. Metadata 220 may be representative of metadata in base design 200, however base design 200 may include additional metadata 220 or less metadata 220 without departing from the scope of the present disclosure.

Industrial unit 210 of base design 200 represents a design for a fully functional industrial unit 210. Industrial unit 210 may be represented in a CAD file or blueprint stored in base design repository 140. In the context of an MCC, industrial unit 210 may be, for example, an industrial automation device such as a circuit breaker, a drive, or any other industrial unit 210 included in an MCC. Industrial unit 210 may include sub-components, in some examples. For example, a Direct On-Line (DOL) motor controller may include an arrangement of auxiliary contacts. In addition to the sub-components, the DOL may include other parameters including, for example, a control scheme, a mounting type, an operator station, a specific overload type, and a safety category. Industrial unit 210 may also be a broader unit such as a cabinet of an MCC, with an arrangement of various motor controllers and other components such as power buses within the cabinet. In an even broader sense, industrial unit 210 may be a fully functional MCC, with an arrangement of all motor controllers and other necessary industrial automation devices, arranged with all relevant connections, in multiple cabinets. As such, base design 200 may define various levels of designs, from individual industrial automation devices (e.g., circuit breakers) to an entire factory of industrial automation devices including their connections and relationships, and everything in between (e.g., an MCC). Base design 200 may be provided to users in response to requests from users to generate an industrial automation project. For example, if a user makes a request for a design of an MCC, industrial design application 120 may generate a design for an MCC by selecting several base designs 200, requesting customized base designs from GAI model 150, and generating a layout of the customized base designs to create a fully functional MCC design customized for the specific user. Alternatively, base design repository 140 may include a base design for an MCC that can be customized by GAI model 150 to meet the needs of the user's request based on the generated prompt. In either case, a user-specific customized design for a fully functional MCC may be generated. A user may further modify the design once the user views the design in industrial design application 120 by changing various selectable options within the design.

Metadata 220 collectively refers to metadata 220a - 220j of base design 200. Metadata 220 includes detailed information about industrial unit 210, which may be stored in one or more taxonomy files. The taxonomy files may include spreadsheets, CAD files, electrical schematic blueprints, and other diagrams and file types for storing the information about industrial unit 210. Specific examples of metadata 220 are provided, but any variation may be used to describe industrial unit 210 without departing from the scope of the present disclosure.

Metadata 220 may include name 220a of industrial unit 210. Name 220a may include, for example, the unit type (e.g., VFD) in addition to an identifying model number. In other examples, a model number, a type of device, or any other name may be used.

Metadata 220 may include description 220b of industrial unit 210. Description 220b may include high-level information about industrial unit 210, as shown, for example, in the high-level overview of configuration list 665 of Fig. 6C. Description 220b may also include detailed industrial specifications for industrial unit 210 in some embodiments.

Metadata 220 may include cost information 220c indicating the cost of industrial unit 210, including various price changes for selections of different selectable options, for example, within option packs 220j discussed below.

Metadata 220 may include lead time 220d, the time-interval between the purchase and delivery of industrial unit 210.

Metadata 220 may include catalog numbers 220e associated with industrial unit 210. Catalog numbers 220e may identify industrial unit 210 or sub-components of industrial unit 210. Catalog numbers 220e may be used for organizing industrial units 210 in a product catalog, for example.

Metadata 220 may include related industries 220f, which may indicate which industries industrial unit 210 is suitable for (e.g., the metals industry or the food and beverage industry).

Metadata 220 may include model artifacts 220g. Model artifacts 220g may include models of industrial unit 210 and may include, for example, CAD files, electrical schematics, single-line diagrams, and mechanical models of industrial unit 210. Model artifacts 220g may further include a layout of industrial unit 210 illustrating, for example, how industrial unit 210 is laid out in a grid.

Metadata 220 may include components information 220h, which may include information about sub-components included in industrial unit 210. For example, some of the sub-components of a motor controller may include control circuitry, an operator station, a circuit breaker, and a housing.

Metadata 220 may include attributes 220i, which may include information about the capabilities of industrial unit 210, such as maximum power ratings.

Metadata 220 may include option packs 220j. There may be one or more option packs 220j, where users can select various options within each option pack 220j. An example option pack 220j is represented in Fig. 8D. Alternatively, when base design 200 is a design for an MCC, for example, the option pack 220j may include information about various substitutable components (e.g., motor controller models that are substitutable for the motor controller models included in base design 200). Each option pack 220j may have a default selection. In generating customized base designs, GAI model 150 may make alternate selections of options within option packs 220j based on learned user preferences.

In practice, base design 200 may be a generic base design (e.g., generic base design 390 of Fig. 3) stored in the base design repository (e.g., base design repository 140 of Figs. 1 and 3). Some or all metadata 220 may be retrieved by industrial design application 120 in response to a user request for a design of an industrial automation project. Industrial design application 120 inserts relevant metadata 220 into a prompt template(e.g., prompt templates 710, 720 of Fig. 7) to generate a prompt for submission to GAI model 150. Once the prompt is submitted to GAI model 150, GAI model 150 customizes metadata 220 of base design 200 based on previous selections and configurations submitted by the specific user. For example, during customization GAI model 150 may modify one or more of description 220b, model artifacts 220g, components information 220h, attributes 220i, option packs 220j, or any combination thereof, based on previous selections made by the user. GAI model 150 thus customizes base design 200 by modifying metadata 220, according to some embodiments. The customized version of base design 200 is incorporated into an industrial automation project, which is presented to the user via a user interface, for example on user device 110 of Fig. 1. The user may then make further changes to base design 200. For example, the user may make alternate selections within option packs 220j, as represented in Fig. 6D. Once the user is satisfied with the industrial automation project, the user may submit the finalized industrial automation project to request a quote, for example.

**Fig. 3** illustrates cloud platform 160 according to some embodiments. Cloud platform 160 includes industrial design application 120, user data repository 130, base design repository 140, and GAI model 150. Cloud platform 160 may be implemented on servers in a datacenter, distributed geographically, and/or the like. Note that GAI model 150 is depicted as part of cloud platform 160 in Fig. 3, however, this is an optional configuration as discussed above with respect to Fig. 1. GAI model 150 may be hosted within cloud platform 160 or externally without departing from the spirit and scope of this disclosure.

User data repository 130 may store information about each user of industrial design application 120. Data for N-number of users is represented by User 1 data 370a, User 2 data 370b, and User N data 370n (collectively, user data 370), where N is any number of users of industrial design application 120. User data 370 includes information about each user including, for example, login information, contact information, and the user's organization or company. User data repository may also include historical user data including previous industrial automation project designs submitted by the user and information about previous purchases by the user. The historical user data in user data repository 130 may be used to train GAI model 150 to learn user-specific preferences for each user. User data repository 130 may also store configuration preferences for users (e.g., preferences from users of previous versions of an industrial design application that existed before GAI model 150 was leveraged or other preferences stored for various users). User information including configuration preferences may be provided to GAI model 150 for user specific training. Leveraging GAI model 150 as disclosed herein reduces the need to store configuration preferences in user data repository 130 because GAI model 150 is trained to provide customizations based on learned preferences.

Base design repository 140 is a repository of generic base designs 390 including Generic Base Design 1 390a, Generic Base Design 2 390b, and Generic Base Design N 390n for N number of generic base designs 390 in base design repository 140. For example, in various embodiments, base design repository 140 may include a few to as many as thousands of generic base designs 390. Generic base designs 390 may be the same configuration as base design 200 as described with respect to Fig. 2. Generic base designs 390 are designs of fully functioning industrial units (e.g., industrial unit 210) which may be included in an industrial automation project. Each generic base design 390 may include an arrangement of sub-components (e.g., industrial automation devices) including, for example, control devices, operator interface devices, and mounting devices. A taxonomy file associated with each base design may include details about the base design including cost information, bill of materials (BOMS) for the base design, and option packs. As one example, a base design for an MCC may be tailored for a specific application. For example, a base design may be tailored for a specific type of pump, conveyor, or mixer in an industrial environment.

Each generic base design 390 in base design repository 140 may be used in an industrial automation project. Each generic base design 390 may include a default configuration including default selections for configurable attributes. GAI model 150 may generate a customized base design for a user in response to receiving a prompt designed to request the customization by customizing a generic base design 390 based on common user selections learned by GAI model 150. With a well-designed prompt and relevant training data, this customization may include the modification of metadata (e.g., metadata 220 of Fig. 2) of generic base design 390, including customized selections within option packs. The modifications are made based on the prompt (e.g., the specific request and provided data) and GAI model 150 training on previous user selections in past industrial automation projects. The user may further modify the customized base designs via industrial design application 120 to arrive at a finalized industrial automation project design.

For example, generic base design 390 may be for a Variable Frequency Drive (VFD) and may include the model of VFD, the type of circuit breaker (e.g. thermal-magnetic), a mounting type (e.g., removable or fixed), the interrupt rating, a space factor indicating the amount of space the VFD will occupy in a cabinet, a type of operator station (e.g., the inclusion of door pushbuttons, indicator lights, and Human Interface Modules), the type of Human Interface Module (HIM) if a HIM is used, whether or not an Electromagnetic Compatibility (EMC) filter is included, the type of line reactor, the safety category, among other features. These features may be configurable attributes of generic base design 390, which may be stored as metadata (e.g., option packs 220j of metadata 220) of generic base design 390. GAI model 150 may generate a customized base design for the VFD based on the submitted prompt. The prompt may request customization of some or all of the configuration features based on prior user submissions. The customized base design may include configurable attributes having selections that align with learned user preferences in GAI model 150. For example, while generic base design 390 may include a thermal-magnetic circuit breaker, GAI model 150 may generate a customized base design with an electronic circuit breaker based on a learned user preference and the prompt requesting such a configuration customization. Once the user receives the customized base design, the user may make further modifications, as discussed further in relation to Figs. 6C and 6D.

Each generic base design 390 may be designed by an engineering team to be tailored to a specific application. The generic base designs 390 may be designed based on component requirements, safety standards, and industry standards. Due to the vast number of possible combinations of the configurable attributes, it is impractical to store every possible configuration as a generic base design 390. Rather, the generic base designs 390 are starting points from which customized base designs can be created. Using the present technology disclosed, GAI model 150 can create the customized base designs based on training and properly designed prompts. Generic base designs 390 include default selections for some or all of the configurable attributes. Such default selections may be provided to users when there are no learned user preferences for specific configurable attributes, when modification creates a safety or other issue, or when the prompt limits the customization. For example, if a user-selected customization selects a power module that is improper for the given design such that it may create a fire hazard, the default selection for the power module will be provided instead of the user-selected customization.

GAI model 150 may be a multi-modal model trained to perform industrial design tasks for industrial design application 120. GAI model 150 may include multi-layered transformer architecture with many parameters (e.g., weights and biases) encoding information. GAI model 150 may be created by training a base generative model to perform industrial design functions. Such a base generative model may be licensed and hosted by a third party. Alternatively, the base generative model may be purchased or provided as an open-source generative model. Base generative models have generally been pre-trained on a vast amount of data. However, even though a base generative model may be pre-trained, it is generally not specifically trained to perform industrial design functions. As such, initial training to perform industrial design tasks may be performed to fine-tune the generative model to perform industrial design tasks. After the initial training, the generative model may be further trained to provide user-specific customizations as discussed in method 400 below.

Industrial design application 120 generates a prompt for GAI model 150 that may include one or more generic base designs 390 selected from base design repository 140 and a user identification associated with the user of industrial design application 120. The prompt may further include the industry and installation location of the industrial automation project. The user identification is contextual information used by GAI model 150 to provide user-specific customization. Specifically, in some embodiments, GAI model 150 is trained on past user configurations for industrial units including user modifications of base designs. GAI model 150 may utilize the user identification in the prompt as contextual information to generate customized base designs specific to the user. In some embodiments, one or more historical industrial automation project designs for the user may be provided in the prompt to use for user context data. GAI model 150 may also use the industry and installation location as contextual information to provide customized base designs that comply with industry standards (e.g., standard configurations and safety standards). GAI model 150 may also use the user's company as contextual information to provide customized base designs that align with the standards and preferences of the user's company. The user's company may have standards or preferences related to cost, safety, and specific configurations (for example, a specific company may typically utilize HIMs in their operator stations). The prompts may be generated using prompt templates (e.g., prompt templates 710, 720 described with respect to Fig. 7).

As one example, a user may request a VFD in a motor-load list when creating a request for a design of an MCC. Industrial design application 120 may select a generic base design 390 for a VFD from base design repository 140, where the generic base design 390 has a default configuration. The VFD may have several configurable attributes, as discussed above. Industrial design application 120 may generate a prompt requesting customization of generic base design 390 for the user. GAI model 150 may have learned a user's specific preferences with respect to the configurable attributes and generate a customized base design for a VFD with selections of the configurable attributes that align with the user's preferences based on the prompt.

As noted above, GAI model 150 may be an LLM capable of processing text or an MMM capable of processing and generating data in a wide range of formats (including, for example, text, images, video, audio, 3-D renderings, and CAD files). In cases in which GAI model 150 is an LLM, metadata 220 of generic base designs 390 in the prompts might, in some embodiments, include only text. The LLM may, in such cases, respond with a customized base design in the form of textual metadata, which could include for example, a textual description of customized selections of the base design. In cases in which GAI model 150 is an MMM, metadata 220 included in the prompt may include, for example, 3-D renderings of the industrial unit 210 or CAD files. The MMM may be prompted to respond with a customized base design in the same format (see, e.g., prompt templates 710, 720 in Fig. 7), and therefore the MMM would generate 3-D renderings or CAD files portraying the customized base design.

While GAI model 150 is leveraged to provide customized base designs, GAI model 150 may also perform other industrial design functions or tasks as prompted by industrial design application 120. For example, GAI model 150 may be trained to update generic base designs 390 in base design repository 140 based on common user selections, generate new generic base designs 390, provide competitive product matching functions, and provide recommendations in response to user selections, among other valuable functions based on the submitted prompt.

Industrial design application 120 interfaces with user data repository 130, base design repository 140, GAI model 150, and user devices 110. Industrial design application 120 includes User Interface (U/I) Module 310, Layout Generation Module 315, User Data Interface Module 320, Graphics Module 325, Base Design Matching Module 330, Prompt Generation Module 335, GAI Update Module 340, and GAI Interface Module 345. While these modules are depicted to describe functionality of industrial design application 120, the functionalities described may be incorporated into more or fewer components, software components, hardware components, firmware components, or a combination without departing from the scope and spirit of the present disclosure.

User Interface (U/I) Module 310 interfaces with user devices 110 and admin devices 112 (see Fig. 1) to implement functionality to display graphical user interfaces (GUIs) and receive inputs from users and administrators. U/I Module 310 sends information for rendering the GUIs on user devices 110 and admin devices 112. U/I Module 310 receives design selections and other inputs from users for designs of industrial automation projects (for example: requests for quotes, process requests for customer assistance, and process customer feedback comments). U/I Module 310 may also receive a request for a design including several user-selected parameters, as shown, for example in user display 600 of Fig. 6A.

Base Design Matching Module 330 selects generic base designs 390 from base design repository 140 based on parameters of the design request submitted by users. Base Design Matching Module 330 utilizes the user request for an industrial automation project design, which is received via U/I Module 310 as discussed above. Base Design Matching Module 330 is configured to select appropriate generic base designs 390 from base design repository 140 based on the parameters in the user's request. In an example, the user may request an MCC. The request may include a motor-load list. Base Design Matching Module 330 may select generic base design 390 for each load in the motor-load list. For example, if the user requests a VFD with a specified rating, base design matching module 330 may select a generic base design 390 for a VFD that meets the customer's request. The selections of generic base designs 390 may be based in part on a user-supplied industry and installation location. For example, if the user selects "Food/Beverage" as the relevant industry, base design matching module 330 may select generic base design 390 that is wash-down safe. Since each country may have unique industrial regulations such as safety regulations, Base Design Matching Module 330 may select generic base design 390 to comply with the regulations of the installation location. Once Base Design Matching Module 330 selects generic base designs 390, the Base Design Matching Module 330 retrieves associated metadata (e.g., metadata 220 of Fig. 2) from base design repository 140.

Prompt Generation Module 335 generates prompts for submission to GAI model 150. The prompt may include metadata (e.g., some or all metadata 220 of Fig. 2) from one or more of generic base designs 390 selected by Base Design Matching Module 330 in addition to a user identification associated with the user. In other embodiments, Prompt Generation Module 335 generates a separate prompt for less than all generic base designs 390 in the industrial automation project, such that each prompt only includes metadata 220 for the relevant generic base designs 390. The number of base designs customized in each prompt may be determined on-the-fly based on, for example, the token limit of GAI model 150. Each prompt may also include the industry and installation location for the industrial automation project. Each user of industrial design application 120 may have a unique user identification included in prompts provided to GAI model 150. The unique user identification may be used to correlate historical designs with the current request. The user identification may be retrieved from user data repository 130, or it may be included in the user's request for a design of the industrial automation project. The prompts may be generated, for example, by filling appropriate data into the placeholders of prompt templates (e.g., prompt templates 710, 720, of Fig. 7).

GAI interface module 345 submits the prompts generated by Prompt Generation Module 335 to GAI model 150. In some embodiments, GAI interface module 345 may return errors, validate responses, modify prompts exceeding timeouts or token limits, or the like. GAI Interface Module 345 receives responses including the customized base designs from GAI model 150.

Layout Generation Module 315 may generate a design layout of the customized base designs to provide to the user. Layout Generation Module 315 may generate a layout including a physical arrangement of the customized base designs received from GAI model 150. While each customized base design may represent an industrial unit in the industrial automation project, Layout Generation Module 315 may generate a complete design for the industrial automation project by arranging each customized base design in a physical location within the design of the industrial automation project, and arranging other required componentry (e.g., power buses, cabinetry, circuit breakers, etc.) within the industrial automation project design. For industrial automation projects that include a single base design, layout generation module 315 may be skipped. Layout Generation Module 315 may generate the layout based on various considerations including safety codes, ease of access for maintenance, temperature control, and space optimization. In the example of an MCC, Layout Generation Module 315 arranges the physical location of each of the customized base designs (which may be designs for motor controllers) and other components (such as circuit breakers and power buses), in a series of one or more cabinets. As such, Layout Generation Module 315 may generate a complete, customized design layout for an industrial automation project (such as an MCC) based on the user's request. Layouts generated by Layout Generation Module 335 are provided to the user via U/I Module 310. An example of a layout for an MCC generated by Layout Generation Module 315 is depicted in user display 600 of Fig. 6B.

Graphics Module 325 generates a graphical representation of the industrial automation project design. A user may request, via U/I Module 310, an alternate graphical representation of the industrial automation project design. For example, a front-facing view of the industrial automation project design may be initially generated by Graphics Module 325 and provided to the user. The user may wish to see a top-down view, or a schematic electrical diagram of the industrial automation project design. In response, Graphics Module 325 generates the requested graphical representations to provide back to the user via U/I Module 310.

GAI Update Module 340 updates GAI model 150 based on a final industrial automation project design selected by users. The user may, for example, modify one or more of the customized base designs, as shown and described, for example, in Fig. 6D. Feedback input is generated by GAI Update Module 340 and provided to GAI model 150 for training GAI model 150 continuously. GAI model 150 updates learned user preferences based on the training. The feedback input may be generated, for example, based on a comparison of the initial system design provided to the user and the final industrial automation project design received from the user, where the final industrial automation project design includes user-made modifications to the customized base designs. The feedback input may include information about each of the modifications made by the user. Alternatively, the feedback input may include the entire industrial automation project submitted by the user for a quote, for example. The feedback input is provided to GAI model 150 to train GAI model 150 with updated user preferences associated with the user.

User Data Interface Module 320 interfaces with user data repository 130 to retrieve account information for users of industrial design application 120. User Data Interface Module 320 may also retrieve historical user data for user-specific training of GAI model 150, where the user-specific training is described below in step 403 of method 400.

In practice, U/I module 310 receives a user request for a design of an industrial automation project. the request may include several parameters for the industrial automation project. Based on the user's parameters, base design matching module 330 may select one or more base designs 390 from base design repository 140 and retrieve the metadata (e.g., metadata 220 of Fig. 2) associated with the selected generic base designs 390 from base design repository 140. Prompt Generation Module 335 incorporates some or all of the metadata from generic base designs 390 into a prompt for GAI model 150. In some embodiments, Prompt Generation Module 335 generates separate prompts for each selected generic base design 390 including the associated metadata. In other embodiments, Prompt Generation Module 335 includes the metadata for all of the selected base designs in a single prompt. In either case, Prompt Generation Module 335 may use a prompt template (e.g., prompt templates 710, 720 of Fig. 7) to generate the prompts. The prompts include the context information and a request designed to elicit a response from GAI model 150 to generate a customization of generic base designs 390 specifically for the user and leveraging historical user data including user-submitted industrial automation projects. GAI Interface Module 345 submits the generated prompts to GAI model 150. GAI model 150 generates customized base designs based on user-specific training and the prompt. GAI model 150 responds to the prompt, providing the response, including the customized base designs to GAI Interface Module 345. Layout Generation Module 315 generates a layout, if needed, for the industrial automation project, including all of the customized base designs. Graphics Module 325 may generate a graphical representation (e.g., a GUI) of the layout. The graphical representation of the layout is provided to user device 110 via U/I Module 310. Once the user has made any desired alterations, the user may submit a finalized design of the industrial automation project. The submission of the finalized design may include, for example, a request for a quote. GAI Update Module 340 may submit the finalized design to GAI Model 150 for updating the user-specific training of GAI Model 150.

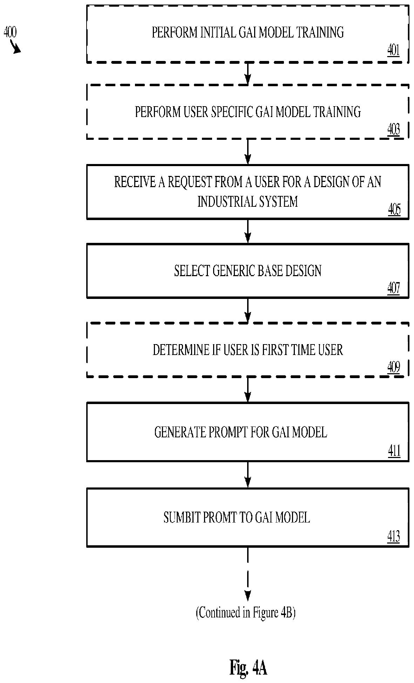

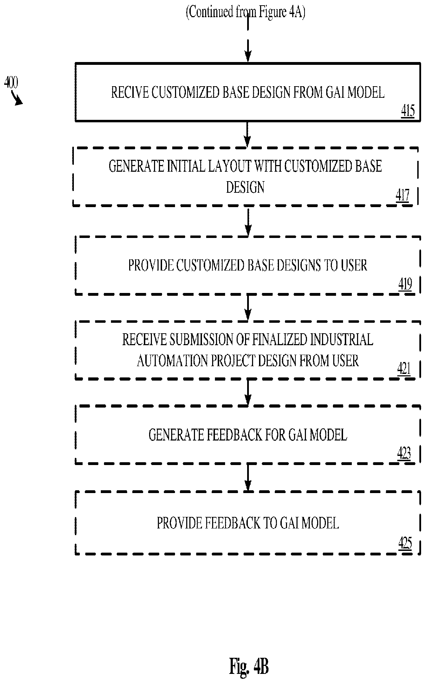

Figs. 4A and 4B illustrate a computer-implemented method 400 for industrial automation project customization. Method 400 may be performed by system 100 and more specifically by industrial design application 120.

Step 401 of method 400 is performing initial training on GAI model 150. In training GAI model 150, parameters of GAI model 150 are adjusted to encode training data. Initial training is generally performed on a base generative model. A base generative model may be licensed and hosted by a third party, purchased, or acquired as an open-source generative model. The base generative model may have been pre-trained on a vast amount of data. **In** general, however, a base generative model is not specifically trained to perform industrial design functions. The initial training in step 401 fine-tunes the base generative model to create GAI model 150 to perform industrial design tasks. The initial training in step 401 may be an unsupervised learning process, including providing the base generative model with static data. The static data may include industrial product literature, industry standard data, data about standard configurations for industrial units, safety requirements in various countries, models of industrial units, existing base designs in base design repository 140, and other data relevant to the industrial systems. In some embodiments, GAI update module 340 may be used to provide the static data to the base generative model to create GAI model 150. In other embodiments, a different training service module may be used.

Step 403 of method 400 is performing user-specific training on GAI model 150. The user-specific training in step 403 may be performed by GAI update module 340 and may be an unsupervised learning process including providing GAI model 150 with historical information for users of industrial design application 120. The historical information may be stored in user data repository 130 and may include previous industrial automation project designs submitted by the users, and previous purchases by the users. GAI model 150 may learn user preferences based on the user selections in previous industrial automation project designs submitted by the user. For example, GAI model 150 may learn that a specific user prefers fixed mounting arrangements for DOL motor controllers in MCCs. In another example, a specific user may tend to select a specific model of VFD when designing an industrial automation project. In the user-specific training of GAI model 150, GAI model 150 learns the user's VFD model preference such that GAI model 150 can generate customized base designs that align with this preference (i.e., that include the preferred model of VFD). User-specific training may be performed for all users of an industrial design application 120 having historical information stored in the user data repository 130. User-specific training may be performed prior to use or completed on-the-fly once a user accesses industrial design application 120.

The historical user data utilized in step 403 may be associated with user activity of industrial design application 120 before GAI model 150 was incorporated or associated with user activity obtained from different systems. Such historical user data may include past user preferences, past industrial automation project design submissions, past purchases, or a combination thereof. Such historical user data is submitted to GAI model 150 for the user along with an associated user identification. GAI model 150 learns user-specific preferences associated with each user by ingesting the historical user data and associated user identifiers.

In some cases, there may not be historical user data associated with a user of the industrial design application, for example when a new user submits a request for the first time. In such a case, GAI model 150 may still generate a customized base design based on the contextual information provided in the prompt (e.g., the installation location and industry indicated by the user, the user's enterprise or company, and the like). For example, general company preferences may be identified and used for new users based on historical information from other users of the company.

In addition to user-specific training based on historical user data, GAI model 150 continually learns user-specific preferences over time. For example, a user's finalized industrial automation project design may be provided to GAI model 150 as feedback, as discussed in greater detail in steps 423 and 425 below.

Step 405 of method 400 is receiving a request for a design of an industrial automation project. The user may create the request on a user interface of a user device such as user device 110a in Fig. 1. The request may include parameters relevant to the request. In the example of an MCC, the request may include a motor-load list as well as the industry and the installation location of the MCC. U/I module 310 may receive the request.

Step 407 of method 400 is selecting one or more generic base designs (e.g., generic base designs 390a, 390b, 390n in base design repository 140). Base design matching module 330 may select generic base designs 390 based on the parameters submitted in the request. In the case of an MCC, for example, a generic base design 390 may be selected for each motor controller included in the motor-load list.

Step 409 of method 400 is determining whether the user is a first-time user. Because GAI model 150 will not have learned user preferences for new users of industrial design application 120, the prompt generated for GAI model 150 may differ depending on whether the user is a first-time user, as discussed in Step 411 below. Prompt generation module 335 may determine if the user is new based on, for example, checking user data repository 130 for user data or historical data associated with the user.

Step 411 of method 400 includes generating a prompt for GAI model 150. The prompt may include the metadata (e.g., some or all of metadata 220 of Fig. 2) of one or more generic base designs 390 selected in Step 407. Prompt generation module 335 may generate the prompt. If it was determined in step 409 that the user is not a first-time user, the prompt includes a user identification associated with the user. The user identification included in the prompt provides GAI model 150 with context for generating a response based on learned user preferences. As such, the user identification in the prompt indicates to the GAI model 150 which user to provide user-specific preferences for. If the user is a first-time user, the generated prompt may not include a user identification since GAI model 150 does not have learned user preferences for new users. However, the user identification may still be included, in some embodiments, for in-context training of GAI model 150. In some embodiments, company standards and preferences may be used for a new user, so a company or enterprise indicator may be included in the prompt, and the prompt may request the customization based on preferences of other users within the company. The prompt may also include the industry and the installation location indicated in the request.

Prompt generation module 335 may use prompt templates, such as the prompt templates 710, 720 shown in Fig. 7, to generate the prompts. Different prompt templates may be used when the user is a first-time user versus when the user is not a first-time user.

Prompt generation module 335 may insert the generic base design metadata 220 into the appropriate placeholder of the prompt template (e.g., prompt templates 710, 720 of Fig. 2). The industry and installation may also be inserted into appropriate placeholders. The user identification, the industry, and the installation location may be used as contextual information by GAI model 150 to provide user-specific customizations that align with industry standards. In some embodiments, the prompt may include additional contextual information including the user's company, the date of the request, and other relevant information. The user's organization (i.e., company or enterprise) may be relevant since GAI model 150 may learn general preferences of an organization in addition to user-specific preferences. The date of the user's request may assist in customization by GAI model 150, since a user's preferences, company standards and preferences, or a combination may change over time, and GAI model 150 may give greater weight to more recent submissions to provide more accurate customizations.

Step 413 of method 400 is submitting the prompt to GAI model 150. As is understood in the art, the prompt may undergo pre-processing steps including vectorization and tokenization for processing by GAI model 150. GAI interface module 345 may submit the prompt to GAI model 150 and perform any needed pre-processing.

Step 415 is receiving one or more customized base designs from GAI model 150. Each customized base design corresponds to one of the one or more generic base designs 390 included in the prompt. GAI interface module 345 may receive the response, including the customized base designs, from GAI model 150. The customized base designs are customized for the specific user based on learned user preferences as requested by the prompt. For example, the customized base design may include one or more different models of industrial automation devices, different configuration selections of configurable attributes, or a combination thereof, as compared to generic base design 390. In some embodiments, the learned user preferences may align with generic base design 390. In such cases, the customized base design provided by GAI model 150 may have some or all of the same selections for configurable options and selections of models of industrial automation devices as generic base design 390.

Step 417 of method 400 is generating an initial layout of the customized base designs in the industrial automation project. Layout generation module 315 may arrange each of the customized base designs in physical locations within the design of the industrial automation project. Layout generation module 315 may further arrange additional componentry within the industrial automation project, including circuitry, cabinetry, control panels, circuit breakers, and the like. Generating the layout may be based on various considerations including safety codes, ease of access for maintenance, temperature control, and space optimization. In the example of an MCC, the layout generation module 315 may arrange the physical location of each of the customized base designs (which may be designs for motor controllers) and other industrial automation devices (e.g., circuit breakers and power buses), in a series of one or more cabinets. An example of a generated layout is shown in user display 600 of Fig. 6B.

Step 417 may apply when the industrial automation project includes multiple customized base designs. When the industrial automation project includes only one customized base design, the customized base design may represent a complete design of the industrial automation project. For example, in a case in which the selected generic base design 390 is a design for an entire MCC, the customized base design may be a design for an entire MCC. In such cases, industrial design application 120 may provide the customized base design to the user without the layout generation of step 417.

Step 419 of method 400 includes providing customized base designs including any generated layout for the industrial automation project to the user. The layout generated in step 417 may be provided to the user via a user interface, as shown, for example, in user interface 600 of Fig. 6B. U/I module 310 may send the information to user device 110 for display. When there is only one customized base design in the industrial automation project, there may not be a generated layout included.

Step 421 of method 400 is receiving a finalized industrial automation project design from the user. The finalized industrial automation project design may include one or more modifications as compared to the initial industrial automation project provided to the user. The user may make modifications to the design in a user interface (e.g., user interface 600 of Figs. 6B - 6C). The user may use the user interfaces to modify configuration settings, change industrial automation devices, or make any other changes. For example, a user may desire a different operator station for a Smart Motor Controller (SMC) than the operator station provided in the customized base design. Accordingly, the user may select the desired operator within an option pack, for example option pack 680 of Fig. 6D. The user may also modify the layout by swapping out a customized base design for a different base design (e.g., by selecting alternative design 660 in Fig. 6C). The user may also rearrange the customized base designs, for example, by dragging and dropping elements representing industrial automation devices in user interface 600 of Fig. 6B. Once the user is satisfied, the user may submit the finalized industrial automation project. The submission of the finalized industrial automation project may include, for example, requesting a quote for purchasing the industrial automation project.

Step 423 of method 400 is generating feedback for GAI model 150 based on the finalized industrial automation project submitted by the user. Providing feedback to GAI model 150 each time a user submits a finalized industrial automation project allows GAI model 150 to continually learn a user's preferences over time. The feedback generated in step 421 may include a user identification such that GAI model 150 may learn user preferences associated with the user based on the user identification. Step 423 may further include determining the differences between the customized base designs and the finalized industrial automation project design and creating a feedback input indicating the determined differences. Alternatively, the entire finalized industrial automation project design may be included in the feedback input for GAI model 150.

Step 425 of method 400 is providing the feedback to GAI model 150. GAI model 150 uses the feedback to update user preferences. GAI model 150 may not update a user preference based on a single selection made by a user. GAI model 150 may consider the frequency of selections made by the user, the changing selections over time, changing industry standards, and any other relevant contextual information for customizing base designs for a specific user. In some embodiments, GAI model 150 may be trained to recognize that a user has made a new selection. GAI model 150 may not automatically update learned user preferences based on a single selection. However, GAI model 150 may be trained to request a user response inquiring whether the user preferences in GAI model 150 should be updated to align with the new selection. In general, learned user preferences in GAI model 150 may be updated based on a variety of factors including the frequency of selections made by a user, the time the selections were made, the variations in industry and installation location selected by the user, the user's organization, and evolving industry standards.

It is expected that, even with the customization provided by GAI model 150, users often make modifications to the customized base designs in industrial design application 120. Ideally, the customized base designs provided by GAI model 150 are as close to the user's preferences as possible to reduce the number of selections that a user needs to make upon receiving the customized base design.

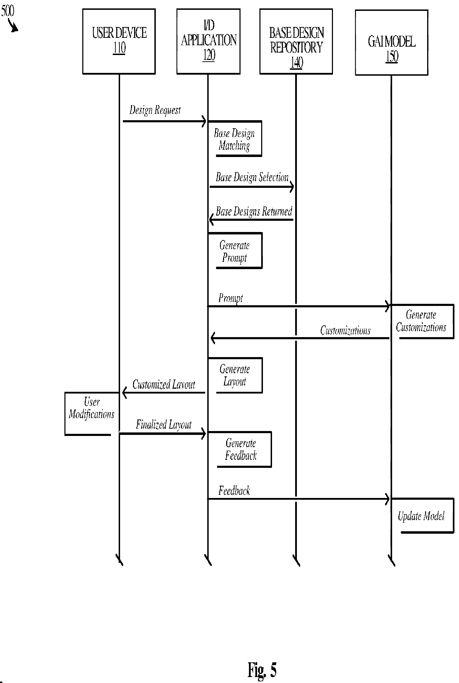

Fig. 5 illustrates an operational scenario 500. Operational scenario 500 includes user device 110, industrial design application 120, base design repository 140, and GAI model 150.

A user using user device 110 submits a design request to industrial design application 120. The design request is a request for a design of an industrial automation project, where the design request includes parameters for the industrial automation project. The design request is created by the user in a user interface of industrial design application 120 displayed on user device 110.

Industrial design application 120 receives the design request. In response to receiving the design request, industrial design application 120 performs a base design matching operation based on the design request using base design matching module 330. Specifically, base design matching module 330 selects generic base designs 390 based on the parameters provided in the request. In the example of MCC design, base design matching module 330 may select a generic base design 390 for a VFD based on the required rating, the industry, and the installation location selected by the user. Base design matching module 330 retrieves the generic base designs 390 from base design repository 140.

Industrial design application 120 generates a prompt for GAI model 150 using prompt generation module 335. The prompt may include metadata (e.g., some or all metadata 220 of Fig. 2) of generic base designs 390 retrieved from base design repository 140 in addition to a user identification associated with the requesting user. The prompt may also include the industry and installation location. In some embodiments, the prompt may also include other contextual information such as the date the user made the request, and the user's organization or company. Each element of the prompt may be represented textually and arranged in an appropriate format for input into GAI model 150. Prompt generation module 335 may use prompt templates (e.g., prompt templates 710, 720 of Fig. 7).

Industrial design application 120 uses GAI interface module 345 to send the prompt to GAI model 150. In response to receiving the prompt, GAI model 150 generates a response to the prompt, which requested customized base designs. The response includes the customized base designs ("customizations"). Each customized base design may include one or more modifications to the generic base designs provided in the prompt, based on learned user preferences and the specific request of the prompt. In some cases, if a generic base design aligns with learned user preferences, the customized base design generated may be substantially similar to the generic base design provided in the prompt. The response is sent from GAI model 150 to GAI interface module 345 of industrial design application 120.

When industrial design application 120 receives the response, including the customized base designs, industrial design application 120 uses layout generation module 315 to generate a customized layout of the customized base designs, when needed. For example, when the industrial automation project is an MCC, layout generation module 315 arranges the customized base designs (representing industrial automation devices such as motor controllers in an MCC) in specific locations in a series of cabinets. Industrial design application 120 may also generate a graphical representation of the layout using graphics module 325. After the customized layout and the graphical representations are generated, industrial design application 120 sends the customized layout and graphical representation to user device 110 via U/I module 310.

The user may make modifications to the customized layout within the user interface of industrial design application 120. For example, the user may select alternate configurations in one or more of the customized base designs. Once the user is satisfied with the layout of the industrial automation project, the user may submit a finalized industrial automation project design, for example, for a quote. Upon submission of the finalized design of the industrial automation project, industrial design application 120 may perform customer service operations such as generating and returning a quote or connecting the user with a sales representative.

Upon receipt of the finalized industrial automation project design, industrial design application 120 may generate feedback using GAI update module 340 for GAI model 150. The feedback may include the entire finalized design. Alternatively, the feedback may include differences extracted between the customized base designs provided by GAI model 150 and the finalized design, indicating user alterations of the customized base designs. Once the feedback has been generated, GAI interface module 345 submits the feedback to GAI model 150. GAI model 150 uses the feedback to update learned user preferences for the user.

**Figs. 6A - 6D** illustrate four different example screens of a user display 600 in industrial design application 120. User display 600 is displayed to a user on a user device (e.g., the user device 110a, 110b, 110n of Fig. 1). User display 600 may be viewed in an internet browser or a specialized application on user device 110. User display 600 shows an example in which the user is requesting a design for an MCC. However, other embodiments of the present technology may include requests for designs of other industrial automation devices.

**Fig. 6A** illustrates a screen of the user display 600 in which a user may create a request for a design of an industrial automation project (in this case, an MCC). In the "Product Selection" field 605, the user selects a desired product. In this case, a user has elected to request a design for a "CENTERLINE IEC Motor Control Center." In the "Project Details" field 610, the user enters parameters for the industrial system to be designed. The "Project Details" field includes a Project Name, a Configuration Name, a Sold to Location, an Installation Location, and the Industry. The illustrated project details 610 are exemplary only. In some embodiments, Installation Location and Industry may be used to generate the prompt as previously discussed, but other information may also provide context and be included in some examples. For example, Industry may be used as contextual information by GAI model 150 to generate customized base designs that are appropriate for the selected industry. For example, in Fig. 6A, the user has selected "Food and Beverage" as the industry. GAI model 150, using this information, may provide a customized design for a motor controller that meets standards for the food and beverage industry.

In addition to Project Details 610, the user creates a motor-load list 615, in this example. The motor-load list includes the controllers a user needs in the MCC, where each controller may be required to drive a certain industrial automation device (e.g., pumps, belts, and mixers) in the industrial automation project. In the or depicted user display 600, for each motor load, the user indicates the name of the MCC, the Load Name, the type of controller required, the rating for the controller, the Rating Unit, and the Full Load Amps (where some fields may not be required depending on the component requested). Clickable fields 620 allow a user to add a new load to the list, copy selected loads, or delete selected loads. When a user is satisfied with the parameters, the user may click the "View Selected Configuration" button 625. Clicking button 625 requests a design of an industrial automation project with the selected parameters and configurations. Clicking button 625 initiates operational scenario 500 of Fig. 5 with the first step of submitting a design request. The user may submit the request with limited parameters as depicted in Fig 6A. Although there are many other relevant parameters in an MCC, industrial design application 120 is configured to identify a relevant base design and request customization from GAI model 150 to generate an initial industrial automation project based on learned industry standards and user-specific data to meet the user's initial request, even when it contains such limited initial information. Thus, submitting a request for a design is efficient, fast, and simple for users, including novice users who may not be familiar with many of the other relevant parameters.

**Fig. 6B** illustrates another screen in user display 600 in which the user has received an initial industrial automation project design from the industrial design application (e.g., industrial design application 120 in Fig. 1). The initial industrial automation project design includes customized base designs generated by GAI model 150 in response to prompts designed by prompt generation module 335 of industrial design application 120. Field 630 displays basic information about the generated design, including the name of the design, the name of the configuration, the Line Voltage, the Control Voltage, and an estimated price for the configuration. Field 635 displays MCCs included in the design. In this example, the user has requested only one MCC; however, users may be able to request a design including multiple MCCs. Design Layout Field 640 shows a graphical depiction of the layout of the industrial automation project design. The initial layout shown in Fig. 6B may be generated, for example, by the Layout Generation Module 315 in Fig. 3. The layout in Design Layout Field 640 shows an arrangement of all the industrial units (industrial units 210) to be included in the MCC. For example, the layout may include a motor controller for each motor controller requested in the motor-load list 615 of Fig. 6A.

The view in Fig. 6B shows high-level information about each customized base design, where each customized base design represents an industrial unit (industrial unit 210) such as a motor controller. For example, the bottom unit in the second column of the MCC design in Fig. 6B is an SMC (Smart Motor Controller). "2Q" indicates the location of the SMC in the generated layout (i.e., position Q of the second column." "Unit 2" indicates the name provided by the user in Fig. 6A. The power and amperage of the SMC is also displayed. A user may select any industrial unit in Design Layout Field 640 to view further details about the configuration of the selected industrial unit, as discussed in relation to Fig. 6C below. The user may click Generate Field 645 to request alternate graphical representations of the MCC (such as a schematic electrical view or a top-down view).

**Fig. 6C** illustrates another screen of user display 600 that is displayed when the user selects an industrial unit from the layout in Fig. 6B. In the example of Fig. 6C, the user has selected "Unit 2" (the SMC). The selection of the component by the user causes Unit Window 670 to be overlayed in user display 600. Configuration list 665 shows details of how the SMC is configured. Configuration list 665 represents multiple configurable attribute selections in the customized base design generated by GAI model 150. For example, the customized base design includes a Mounting Type of "Withdrawable," which may be based on a learned user-preference of GAI model 150 that a specific user usually prefers withdrawable mounting for SMCs. The user has the option of swapping the design of the SMC for alternative design 660, which may be additional customized base designs generated by GAI model 150. Alternatively, alternative designs 660 may be generic base designs selected from the base design repository (such as base design repository 140 in Fig. 1). A user also has the option of editing the details of the design of the unit (the SMC) provided by clicking "Edit Unit Details" button 555.

**Fig. 6D** illustrates another screen of user display 600 that is displayed after a user has selected Edit Unit Details Button 655 of Fig. 6C. Specifically, upon the user request to edit the unit details, Unit Configuration Window 675 appears on screen. Unit Configuration Window 675 includes option packs 680 of the unit the user requested to edit. Each option pack 680 includes selectable options 685 which are selectable by the user to configure the unit. The user may edit the configuration of the unit by selecting one of option packs 680 and making a selection of one of selectable options 685. In this case, the user has selected "Operator Station." The user may then select one of selectable options 685. This allows the user to deviate from the customized base design provided by GAI model 150. Option packs 680 may be option packs 220j of Fig. 2.

As an example, a generic base design (e.g., in base design repository 140 of Fig. 1) may include an operator station with a default selection of a 3-Position Switch, three indicator lights (G, Red, and Amber) and a HIM (see the top-left selectable option of selectable options 685). Such a generic base design may be selected for example, in step 407 of method 400. However, GAI model 150 may have learned based on past usage that the user requesting the design usually wants only a HIM (which may be, for example, for cost saving purposes). As such, the customized base design generated by GAI model 150 may include "With HIM" as an operator station (the third option on the right). Such a customized base design may be received in step 413 of method 400. In the present design, the user does not require an operator station for a particular SMC; thus, the user has deviated from the customized base design by selecting "Without Operator Station" on the top right. Once the user makes all the desired alterations in various option packs 680, the user arrives at a finalized unit design. It is noted that the customized base design provided to the user is meant to predict as closely as possible what a user wants for a particular unit. Specifically, GAI model 150 generally provides customized base designs that are closer than the generic base designs to the user's finalized design, thus reducing the number of alterations the user makes to arrive at the finalized unit design.

**Fig. 7** illustrates prompt templates 710, 720 according to some embodiments. Prompt templates 710, 720 are files stored in industrial design application 120. Prompt templates 710, 720 may include a combination of text and placeholders, where the placeholders are replaced with the relevant data during prompt generation as discussed below. Prompt templates 710, 720 may be utilized, for example, by Prompt Generation Module 335 in Fig. 3 to generate prompts for GAI model 150.

Prompt template 710 may be used when the user of the industrial design application (for example industrial design application 120 of Fig. 1) is not a first-time user. This may be determined, for example, in step 409 of method 400 in Figs. 4A and 4B as discussed above. Prompt template 710 includes multiple placeholders that are filled in with appropriate data to generate the prompt. The placeholders in prompt template 710 include <base design metadata>, <user identification>, <installation location>, <industry>, and <company name>. During prompt generation, the placeholder <base design metadata> is filled with information about the generic base design, such as the metadata of the generic base design selected from base design repository 140 of Fig. 1. This may include, for example, some or all of metadata 220 of Fig. 2. The <user identification> placeholder is filled with a user identification associated with the user of the industrial design application. Similarly, the <industry> placeholder is filled in with the relevant industry (such as "Food / Beverage"), the <installation location> placeholder is filled in with the installation location (such as "Canada"), and the <company name> placeholder is filled in with the user's company (such as "XYZ Incorporated"). The prompt template includes a request to generate a customized base design for the user.

Prompt template 720 may be used when the user of the industrial design application (for example industrial design application 120 of Fig. 1) is a first-time user. This may be determined, for example, in step 409 of method 400 in Figs. 4A and 4B as discussed above. Prompt template 720 is the similar to prompt template 710, except that it does not include the preferences of the user in the request. GAI model 150 might not have learned user preferences for a new user of the application, and as such, the prompt includes a request to generate the customized base design based on the generic base design, installation location, and industry.

Once the prompt is generated based on the prompt template, and the prompt is provided to GAI model 150, GAI model 150 uses all the information in the prompt as contextual information to generate a customized base design. It is noted that prompt templates 710, 720 are representative. Other embodiments may include different request language, and may include additional placeholders, or fewer placeholders.

**Fig. 8** illustrates computing system 801 that is representative of any system or collection of systems in which the various processes, programs, services, and scenarios disclosed herein may be implemented. Examples of computing system 801 include, but are not limited to, desktop and laptop computers, tablet computers, mobile computers, and wearable devices. Examples may also include server computers, web servers, cloud computing platforms, and data center equipment, as well as any other type of physical or virtual server machine, container, and any variation or combination thereof.

Computing system 801 may be implemented as a single apparatus, system, or device or may be implemented in a distributed manner as multiple apparatuses, systems, or devices. Computing system 801 includes, but is not limited to, processing system 802, storage system 803, software 805, communication interface system 807, and user interface system 809. Processing system 802 is operatively coupled with storage system 803, communication interface system 807, and user interface system 809.

Processing system 802 loads and executes software 805 from storage system 803. Software 805 includes and implements industrial design application 120, which is (are) representative of the application service processes discussed with respect to the preceding figures, such as method 400 of Figs. 4A and 4B. In some embodiments, industrial design application 120 may be implemented in a cloud-based system. Nonetheless, industrial design application 120 may be implemented as software executed by processors as depicted in Fig. 8. When executed by processing system 802, software 805 directs processing system 802 to operate as described herein for at least the various processes, operational scenarios, and sequences discussed in the foregoing implementations. Computing system 801 may optionally include additional devices, features, or functionality not discussed for purposes of brevity.

Referring still to Fig. 8, processing system 802 may comprise a microprocessor and other circuitry that retrieves and executes software 805 from storage system 803. Processing system 802 may be implemented within a single processing device but may also be distributed across multiple processing devices or sub-systems that cooperate in executing program instructions. Examples of processing system 802 include general purpose central processing units, graphical processing units, application specific processors, and logic devices, as well as any other type of processing device, combinations, or variations thereof.

Storage system 803 may comprise any computer-readable storage media device readable by processing system 802 and capable of storing software 805. Storage system 803 may include volatile and nonvolatile, removable, and non-removable media implemented in any method or technology for storage of information, such as computer readable software instructions, data structures, program modules, or other data. Examples of storage media include random access memory, read only memory, magnetic disks, optical disks, flash memory, virtual memory and non-virtual memory, magnetic cassettes, magnetic tape, magnetic disk storage or other magnetic storage devices, or any other suitable storage media. In no case is the computer readable storage media a propagated or transitory signal.

In addition to computer-readable storage media, in some implementations storage system 803 may also include computer readable communication media over which at least some of software 805 may be communicated internally or externally. Storage system 803 may be implemented as a single storage device but may also be implemented across multiple storage devices or sub-systems co-located or distributed relative to each other. Storage system 803 may comprise additional elements, such as a controller, capable of communicating with processing system 802 or possibly other systems.

Software 805 (including industrial design application 120) may be implemented in program instructions and among other functions may, when executed by processing system 802, direct processing system 802 to operate as described with respect to the various operational scenarios, sequences, and processes illustrated herein. For example, software 805 may include program instructions for implementing an application service process as described herein.

In particular, the program instructions may include various components or modules that cooperate or otherwise interact to carry out the various processes and operational scenarios described herein. The various components or modules may be embodied in compiled or interpreted instructions, or in some other variation or combination of instructions. The various components or modules may be executed in a synchronous or asynchronous manner, serially or in parallel, in a single threaded environment or multi-threaded, or in accordance with any other suitable execution paradigm, variation, or combination thereof. Software 805 may include additional processes, programs, or components, such as operating system software, virtualization software, or other application software. Software 805 may also comprise firmware or some other form of machine-readable processing instructions executable by processing system 802.

In general, software 805 may, when loaded into processing system 802 and executed, transform a suitable apparatus, system, or device (of which computing system 801 is representative) overall from a general-purpose computing system into a special-purpose computing system customized to support an application service in an optimized manner. Indeed, encoding software 805 on storage system 803 may transform the physical structure of storage system 803. The specific transformation of the physical structure may depend on various factors in different implementations of this description. Examples of such factors may include, but are not limited to, the technology used to implement the storage media of storage system 803 and whether the computer-storage media are characterized as primary or secondary storage, as well as other factors.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number, respectively. The word "or," in reference to a list of two or more items, covers all of the following interpretations of the word: any of the items in the list, all of the items in the list, and any combination of the items in the list.

The above Detailed Description of examples of the technology is not intended to be exhaustive or to limit the technology to the precise form disclosed above. While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or subcombinations. Each of these processes or blocks may be implemented in a variety of different ways. Also, while processes or blocks are at times shown as being performed in series, these processes or blocks may instead be performed or implemented in parallel or may be performed at different times. Further any specific numbers noted herein are only examples: alternative implementations may employ differing values or ranges.

The teachings of the technology provided herein can be applied to other systems, not necessarily the system described above. The elements and acts of the various examples described above can be combined to provide further implementations of the technology. Some alternative implementations of the technology may include not only additional elements to those implementations noted above, but also may include fewer elements.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a means-plus-function claim. Any claims intended to be treated under 35 U.S.C. § 112(f) will begin with the words "means for", but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.

**The following is a list of further preferred embodiments of the invention:**
Embodiment 1. A computer-implemented method for industrial design customization, the method comprising:
   receiving, via a user interface of an industrial design application, a request from a user for a design of an industrial automation project, wherein the request comprises one or more system parameters;
   selecting, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
   generating a prompt to elicit a response from a generative artificial intelligence (GAI) model trained on data including prior designs associated with the user, wherein the prompt comprises:
      the metadata of the first generic base design,
      a user identification associated with the user, and
      a request for a customization of the first generic base design for the user;
   submitting the prompt to the GAI model;
   receiving, from the GAI model in response to the prompt, a first customized base design, wherein the first customized base design comprises one or more configurable attributes that differ from corresponding configurable attributes in the first generic base design and are representative of selections in the prior designs associated with the user; and
   providing the first customized base design to the user via the user interface.
Embodiment 2. The computer-implemented method of embodiment 1, further comprising:
   receiving a finalized unit design from the user via the user interface, wherein the finalized unit design comprises one or more modifications to the first customized base design, the modifications being made by the user in the user interface of the industrial design application.
Embodiment 3. The computer-implemented method of embodiment 2, further comprising:
   submitting the finalized unit design to the GAI model as feedback to train the GAI model on selections of configurable attributes associated with the user.
Embodiment 4. The computer-implemented method of embodiment 1, further comprising:
   providing the GAI model with static data during initial training, the static data comprising one or more of: industrial product literature, industry standard data, and safety requirements data.
Embodiment 5. The computer-implemented method of embodiment 1, wherein the user is one of a plurality of users of the industrial design application, wherein the method further comprises:
   providing the GAI model with historical user data during user-specific training, wherein the historical user data comprises past industrial configuration submissions, each past industrial configuration submission being associated with one of the plurality of users.
Embodiment 6. The computer-implemented method of embodiment 1, further comprising:
   selecting, based on the one or more system parameters, a set of generic base designs from the plurality of generic base designs in the base design repository, the set of generic base designs including the first generic base design;
   generating a respective prompt for each generic base design in the set of generic base designs, each respective prompt comprising the metadata of the respective generic base design, the user identification, and a request for customization of the respective generic base design for the user;
   receiving, from the GAI model in response to the plurality of prompts, a set of customized base designs corresponding to the set of generic base designs, wherein the set of customized base designs includes the first customized base design; and
   generating a design layout comprising an arrangement of the set of customized base designs, wherein each customized base design in the set of customized base designs corresponds to an industrial unit in the industrial automation project.
Embodiment 7. The computer-implemented method of embodiment 1, wherein the system parameters of the request comprise:
   an industry,
   an installation location, and
   a load list for the industrial automation project.
Embodiment 8. The computer-implemented method of embodiment 1, wherein the request for the design for the industrial automation project comprises a request for a design of a Motor Control Center, and wherein the first customized base design comprises a customized configuration for a motor controller in the Motor Control Center.
Embodiment 9. A system for industrial design customization, the system comprising:
   one or more processors; and
   one or more memories operably coupled to the one or more processors and having stored thereon software instructions that, upon execution by the one or more processors, cause the one or more processors to:
      receive, via a user interface of an industrial design application, a request from a user for a design of an industrial automation project, wherein the request comprises one or more system parameters;
      select, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
      generate a prompt to elicit a response from a generative artificial intelligence (GAI) model trained on data including prior designs associated with the user, wherein the prompt comprises:
         the metadata of the first generic base design,
         a user identification associated with the user, and
         a request for a customization of the first generic base design for the user;
      submit the prompt to the GAI model;
      receive, from the GAI model in response to the prompt, a first customized base design, wherein the first customized base design comprises one or more configurable attributes that differ from corresponding configurable attributes in the first generic base design and are representative of selections in the prior designs associated with the user; and
      provide the first customized base design to the user via the user interface.
Embodiment 10. The system of embodiment 9, wherein the software instructions comprise further instructions that, upon execution by the one or more processors, cause the one or more processors to:
   receive a finalized unit design from the user via the user interface, wherein the finalized unit design comprises one or more modifications to the first customized base design, the modifications being made by the user in the user interface of the industrial design application.
Embodiment 11. The system of embodiment 10, wherein the software instructions comprise further instructions that, upon execution by the one or more processors, cause the one or more processors to:
   submit the finalized unit design to the GAI model as feedback to train the GAI model on selections of configurable attributes associated with the user.
Embodiment 12. The system of embodiment 9, wherein the software instructions comprise further instructions that, upon execution by the one or more processors, cause the one or more processors to:
   provide the GAI model with static data during initial training, the static data comprising one or more of: industrial product literature, industry standard data, and safety requirements data.
Embodiment 13. The system of embodiment 9, wherein the user is one of a plurality of users, wherein the software instructions comprise further instructions that, upon execution by the one or more processors, cause the one or more processors to:
   provide the GAI model with historical user data during user-specific training, wherein the historical user data comprises past industrial configuration submissions, each past industrial configuration submission being associated with one of the plurality of users.
Embodiment 14. The system of embodiment 9, wherein the software instructions comprise further instructions that, upon execution by the one or more processors, cause the one or more processors to:
   select, based on the one or more system parameters, a set of generic base designs from the plurality of generic base designs in the base design repository, the set of generic base designs including the first generic base design;
   generate a respective prompt for each generic base design in the set of generic base designs, each respective prompt comprising the metadata of the respective generic base design, the user identification, and a request for customization of the respective generic base design for the user;
   receive from the GAI model, in response to the plurality of prompts, a set of customized base designs corresponding to the set of generic base designs, wherein the set of customized base designs includes the first customized base design; and
   generate a design layout comprising an arrangement of the set of customized base designs, wherein each customized base design in the set of customized base designs corresponds to an industrial unit in the industrial automation project.
Embodiment 15. The system of embodiment 9, wherein the system parameters of the request comprise:
   an industry,
   an installation location, and
   a load list for the industrial automation project.
Embodiment 16. The system of embodiment 9, wherein the request for the design for the industrial automation project comprises a request for a design of a Motor Control Center, and wherein the first customized base design comprises a customized configuration for a motor controller in the Motor Control Center.
Embodiment 17. A computer-readable storage media device having program instructions stored thereon for industrial design customization, wherein the program instructions, upon execution by one or more processors, cause the one or more processors to:
   receive, via a user interface of an industrial design application, a request from a user for a design of an industrial automation project, wherein the request comprises one or more system parameters;
   select, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
   generate a prompt to elicit a response from a generative artificial intelligence (GAI) model trained on data including prior designs associated with the user, wherein the prompt comprises:
      the metadata of the first generic base design,
      a user identification associated with the user, and
      a request for a customization of the first generic base design for the user;
      submit the prompt to the GAI model;
      receive, from the GAI model in response to the prompt, a first customized base design, wherein the first customized base design comprises one or more configurable attributes that differ from corresponding configurable attributes in the first generic base design and are representative of selections in the prior designs associated with the user; and
      provide the first customized base design to the user via the user interface.
Embodiment 18. The computer-readable storage media device of embodiment 17, wherein the program instructions comprise further program instructions that, upon execution by the one or more processors, cause the one or more processors to:
   receive a finalized unit design from the user via the user interface, wherein the finalized unit design comprises one or more modifications to the first customized base design, the modifications being made by the user in the user interface of the industrial design application.
Embodiment 19. The computer-readable storage media device of embodiment 18, wherein the program instructions comprise further program instructions that, upon execution by the one or more processors, cause the one or more processors to:
   submit the finalized unit design to the GAI model as feedback to train the GAI model on selections of configurable attributes associated with the user.
Embodiment 20. The computer-readable storage media device of embodiment 17, wherein the request for the design for the industrial automation project comprises a request for a design of a Motor Control Center, and wherein the first customized base design comprises a customized configuration for a motor controller in the Motor Control Center.

## Claims

1. A computer-implemented method for industrial design customization, the method comprising:
receiving, via a user interface of an industrial design application, a request from a user for a design of an industrial automation project, wherein the request comprises one or more system parameters;
selecting, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
generating a prompt to elicit a response from a generative artificial intelligence (GAI) model trained on data including prior designs associated with the user, wherein the prompt comprises:
the metadata of the first generic base design,
a user identification associated with the user, and
a request for a customization of the first generic base design for the user;
submitting the prompt to the GAI model;
receiving, from the GAI model in response to the prompt, a first customized base design, wherein the first customized base design comprises one or more configurable attributes that differ from corresponding configurable attributes in the first generic base design and are representative of selections in the prior designs associated with the user; and
providing the first customized base design to the user via the user interface.

2. The computer-implemented method of claim 1, further comprising:
receiving a finalized unit design from the user via the user interface, wherein the finalized unit design comprises one or more modifications to the first customized base design, the modifications being made by the user in the user interface of the industrial design application; and
submitting the finalized unit design to the GAI model as feedback to train the GAI model on selections of configurable attributes associated with the user.

3. The computer-implemented method of claim 1 or 2, further comprising:
providing the GAI model with static data during initial training, the static data comprising one or more of: industrial product literature, industry standard data, and safety requirements data.

4. The computer-implemented method of one of claims 1 to 3, wherein the user is one of a plurality of users of the industrial design application, wherein the method further comprises:
providing the GAI model with historical user data during user-specific training, wherein the historical user data comprises past industrial configuration submissions, each past industrial configuration submission being associated with one of the plurality of users.

5. The computer-implemented method of one of claims 1 to 4, further comprising:
selecting, based on the one or more system parameters, a set of generic base designs from the plurality of generic base designs in the base design repository, the set of generic base designs including the first generic base design;
generating a respective prompt for each generic base design in the set of generic base designs, each respective prompt comprising the metadata of the respective generic base design, the user identification, and a request for customization of the respective generic base design for the user;
receiving, from the GAI model in response to the plurality of prompts, a set of customized base designs corresponding to the set of generic base designs, wherein the set of customized base designs includes the first customized base design; and
generating a design layout comprising an arrangement of the set of customized base designs, wherein each customized base design in the set of customized base designs corresponds to an industrial unit in the industrial automation project.

6. The computer-implemented method of one of claims 1 to 5, wherein:
the system parameters of the request comprise, an industry, an installation location, and a load list for the industrial automation project; and/or
the request for the design for the industrial automation project comprises a request for a design of a Motor Control Center, and wherein the first customized base design comprises a customized configuration for a motor controller in the Motor Control Center.

7. A system for industrial design customization, the system comprising:
one or more processors; and
one or more memories operably coupled to the one or more processors and having stored thereon software instructions that, upon execution by the one or more processors, cause the one or more processors to:
receive, via a user interface of an industrial design application, a request from a user for a design of an industrial automation project, wherein the request comprises one or more system parameters;
select, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
generate a prompt to elicit a response from a generative artificial intelligence (GAI) model trained on data including prior designs associated with the user, wherein the prompt comprises:
the metadata of the first generic base design,
a user identification associated with the user, and
a request for a customization of the first generic base design for the user;
submit the prompt to the GAI model;
receive, from the GAI model in response to the prompt, a first customized base design, wherein the first customized base design comprises one or more configurable attributes that differ from corresponding configurable attributes in the first generic base design and are representative of selections in the prior designs associated with the user; and
provide the first customized base design to the user via the user interface.

8. The system of claim 7, wherein the software instructions comprise further instructions that, upon execution by the one or more processors, cause the one or more processors to:
receive a finalized unit design from the user via the user interface, wherein the finalized unit design comprises one or more modifications to the first customized base design, the modifications being made by the user in the user interface of the industrial design application; and
submit the finalized unit design to the GAI model as feedback to train the GAI model on selections of configurable attributes associated with the user.

9. The system of claim 7 or 8, wherein:
the software instructions comprise further instructions that, upon execution by the one or more processors, cause the one or more processors to provide the GAI model with static data during initial training, the static data comprising one or more of, industrial product literature, industry standard data, and safety requirements data; and/or
the user is one of a plurality of users, wherein the software instructions comprise further instructions that, upon execution by the one or more processors, cause the one or more processors to provide the GAI model with historical user data during user-specific training, wherein the historical user data comprises past industrial configuration submissions, each past industrial configuration submission being associated with one of the plurality of users.

10. The system of one of claim 7 to 9, wherein the software instructions comprise further instructions that, upon execution by the one or more processors, cause the one or more processors to:
select, based on the one or more system parameters, a set of generic base designs from the plurality of generic base designs in the base design repository, the set of generic base designs including the first generic base design;
generate a respective prompt for each generic base design in the set of generic base designs, each respective prompt comprising the metadata of the respective generic base design, the user identification, and a request for customization of the respective generic base design for the user;
receive from the GAI model, in response to the plurality of prompts, a set of customized base designs corresponding to the set of generic base designs, wherein the set of customized base designs includes the first customized base design; and
generate a design layout comprising an arrangement of the set of customized base designs, wherein each customized base design in the set of customized base designs corresponds to an industrial unit in the industrial automation project.

11. The system of one of claims 7 to 10, wherein:
the system parameters of the request comprise an industry, an installation location, and a load list for the industrial automation project; and/or
the request for the design for the industrial automation project comprises a request for a design of a Motor Control Center, and wherein the first customized base design comprises a customized configuration for a motor controller in the Motor Control Center.

12. A computer-readable storage media device having program instructions stored thereon for industrial design customization, wherein the program instructions, upon execution by one or more processors, cause the one or more processors to:
receive, via a user interface of an industrial design application, a request from a user for a design of an industrial automation project, wherein the request comprises one or more system parameters;
select, based on the one or more system parameters, a first generic base design from a base design repository, wherein the first generic base design is one of a plurality of generic base designs stored in the base design repository, wherein each of the plurality of generic base designs comprises metadata defining an industrial unit, and wherein the metadata of the first generic base design comprises a first selection of a configurable attribute;
generate a prompt to elicit a response from a generative artificial intelligence (GAI) model trained on data including prior designs associated with the user, wherein the prompt comprises:
the metadata of the first generic base design,
a user identification associated with the user, and
a request for a customization of the first generic base design for the user;
submit the prompt to the GAI model;
receive, from the GAI model in response to the prompt, a first customized base design, wherein the first customized base design comprises one or more configurable attributes that differ from corresponding configurable attributes in the first generic base design and are representative of selections in the prior designs associated with the user; and
provide the first customized base design to the user via the user interface.

13. The computer-readable storage media device of claim 12, wherein the program instructions comprise further program instructions that, upon execution by the one or more processors, cause the one or more processors to:
receive a finalized unit design from the user via the user interface, wherein the finalized unit design comprises one or more modifications to the first customized base design, the modifications being made by the user in the user interface of the industrial design application.

14. The computer-readable storage media device of claim 13, wherein the program instructions comprise further program instructions that, upon execution by the one or more processors, cause the one or more processors to:
submit the finalized unit design to the GAI model as feedback to train the GAI model on selections of configurable attributes associated with the user.

15. The computer-readable storage media device of claim 12, wherein the request for the design for the industrial automation project comprises a request for a design of a Motor Control Center, and wherein the first customized base design comprises a customized configuration for a motor controller in the Motor Control Center.
